(19) Europäisches Patentamt
European Patent Office
Office européen des brevets

(11) **EP 4 283 754 A1**

(12) **EUROPEAN PATENT APPLICATION**
published in accordance with Art. 153(4) EPC

(43) Date of publication:
**29.11.2023 Bulletin 2023/48**

(21) Application number: **21920954.1**

(22) Date of filing: **20.01.2021**

(51) International Patent Classification (IPC):
**H01M 10/48** (2006.01)   **H02J 7/00** (2006.01)
**G01R 31/385** (2019.01)

(52) Cooperative Patent Classification (CPC):
**G01R 31/385; H01M 10/48; H02J 7/00**

(86) International application number:
**PCT/JP2021/001760**

(87) International publication number:
**WO 2022/157840 (28.07.2022 Gazette 2022/30)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **InsuRTAP Inc.**
**Tokyo 107-0082 (JP)**

(72) Inventor: **KOSUG,I Shinichiro**
**Tokyo 107-0082 (JP)**

(74) Representative: **Betten & Resch**
**Patent- und Rechtsanwälte PartGmbB**
**Maximiliansplatz 14**
**80333 München (DE)**

(54) **DIAGNOSTIC DEVICE, DIAGNOSTIC METHOD, AND PROGRAM**

(57)   The present invention provides a diagnostic apparatus (60) including a diagnosis unit (61) that diagnoses a state of health of a power storage apparatus based on an item value that is a difference between a reference value and an open-circuit voltage, the reference value being obtained by subtracting an open-circuit potential of a negative electrode of the power storage apparatus from an open-circuit potential of a positive electrode of the power storage apparatus.

FIG. 10

**Description**

TECHNICAL FIELD

The present invention relates to a diagnostic apparatus, a diagnostic method, and a program.

BACKGROUND ART

Non-Patent Document 1 discloses a technique for recognizing a state of health of a battery from a behavior in charging. Non-Patent Document 1 discloses a method of obtaining a positive electrode capacity, a negative electrode capacity, an inactivated Li ion content, and a state of charge of a negative electrode. Non-Patent Documents 2 and 3 disclose a voltage hysteresis. Patent Document 1 discloses a method of determining a deterioration state of a lithium-ion battery.

RELATED DOCUMENT

PATENT DOCUMENT

[Patent Document 1] Japanese Patent No. 5537236

NON-PATENT DOCUMENT

[Non-Patent Document 1] MORITA Tomokazu, and two others. "Charging Curve Analysis Method to Visualize State of Health of Lithium-Ion Batteries through Internal State Estimation", [online], [Searched on October 8, 2019], Internet <URL: https://www.toshiba.co.jp/tech/review/2013/10/68_10pdf/f07.pdf>
[Non-Patent Document 2] Rashid, M, Pathan, T, McGordon, A, Kendrick, E & Widanage, "Investigation of hysteresis and relaxation behaviour in graphite and LiNi Mn Co O electrodes", Journal of Power Sources, vol. 440, 227153, 2019
[Non-Patent Document 3] F. Baronti, W. Zamboni, N. Femia, R. Roncella, and R. Saletti, "Experimental Analysis of Open-Circuit Voltage Hysteresis in Lithium-Iron-Phosphate Batteries", IECON 2013 -39th Annual Conference of the IEEE Industrial Electronics Society, 978-1-4799-0224-8/13, 2013

DISCLOSURE OF THE INVENTION

TECHNICAL PROBLEM

A power storage apparatus when subjected to thermal runaway may cause a disaster, such as burning, by severely ejecting flame. Thus, it is desirable to diagnose a state of health of a power storage apparatus with various methods from various aspects.
An object of the present invention is to provide a new method that diagnoses a state of health of a power storage apparatus.

SOLUTION TO PROBLEM

According to the present invention, there is provided a diagnostic apparatus including:
a diagnosis unit that diagnoses a state of health of a power storage apparatus based on an item value that is a difference between a reference value and an open-circuit voltage, the reference value being obtained by subtracting an open-circuit potential of a negative electrode of the power storage apparatus from an open-circuit potential of a positive electrode of the power storage apparatus.
According to the present invention, there is provided a diagnostic method including, via a computer:
diagnosing a state of health of a power storage apparatus based on an item value that is a difference between a reference value and an open-circuit voltage, the reference value being obtained by subtracting an open-circuit potential of a negative electrode of the power storage apparatus from an open-circuit potential of a positive electrode of the power storage apparatus.
According to the present invention, there is provided a program causing a computer to function as:
diagnosis unit that diagnoses a state of health of a power storage apparatus based on an item value that is a difference between a reference value and an open-circuit voltage, the reference value being obtained by subtracting an open-circuit potential of a negative electrode of the power storage apparatus from an open-circuit potential of a positive electrode of the power storage apparatus.

ADVANTAGEOUS EFFECTS OF INVENTION

According to the present invention, a new method that diagnoses the state of health of the power storage apparatus is realized.

BRIEF DESCRIPTION OF THE DRAWINGS

The above-described object and other objects, features and advantages will be further clarified by the preferred example embodiments described below and the following drawings attached thereto.
[Fig. 1] It is a diagram illustrating an overall configuration of an authentication system of the present example embodiment.
[Fig. 2] It is a diagram illustrating a flow of data of the authentication system of the present example embodiment.
[Fig. 3] It is a diagram illustrating an example of a hardware configuration of an apparatus of the present example embodiment.
[Fig. 4] It is an example of a functional block diagram of a monitoring server of the present example embodiment.
[Fig. 5] It is a diagram illustrating processing of a diagnosis unit of the present example embodiment.
[Fig. 6] It is a diagram illustrating processing of the diagnosis unit of the present example embodiment.
[Fig. 7] It is a diagram illustrating processing of the diagnosis unit of the present example embodiment.
[Fig. 8] It is a sequence diagram illustrating an example of a flow of processing of the authentication system of the present example embodiment.
[Fig. 9] It is a diagram illustrating processing of the diagnosis unit of the present example embodiment.
[Fig. 10] It is an example of a functional block diagram of a diagnostic apparatus of the present example embodiment.
[Fig. 11] It is a diagram illustrating processing of the diagnosis unit of the present example embodiment.
[Fig. 12] It is a diagram illustrating positive and negative electrode deviation of the present example embodiment.
[Fig. 13] It is a diagram illustrating processing of the diagnosis unit of the present example embodiment.
[Fig. 14] It is a diagram illustrating processing of the diagnosis unit of the present example embodiment.
[Fig. 15] It is a diagram illustrating processing of the diagnosis unit of the present example embodiment.
[Fig. 16] It is a diagram illustrating processing of the diagnosis unit of the present example embodiment.
[Fig. 17] It is a diagram illustrating processing of the diagnosis unit of the present example embodiment.

DESCRIPTION OF EMBODIMENTS

<First Example Embodiment>

"Overall Configuration of Authentication System"

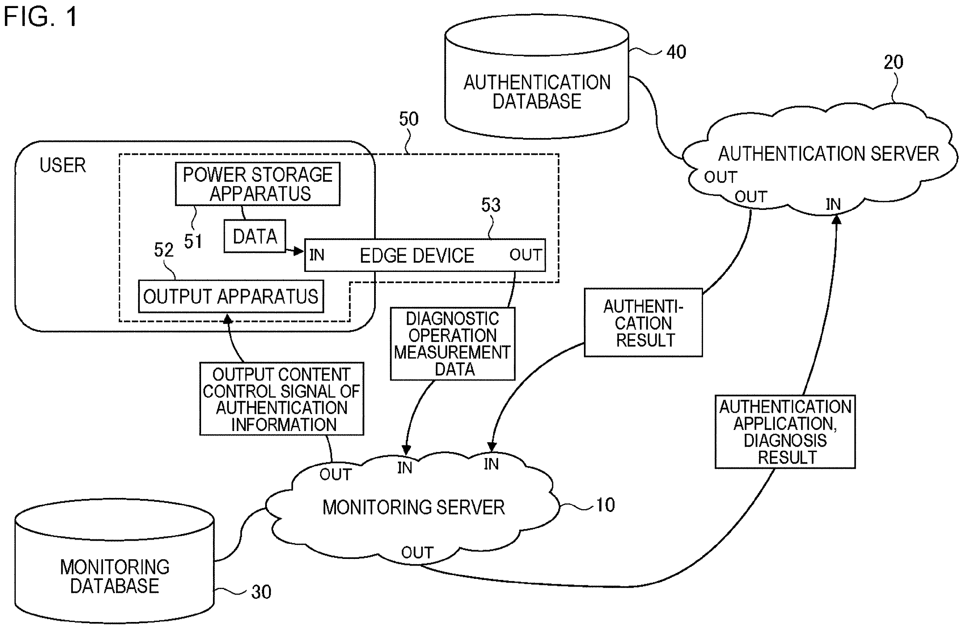

First, the overall configuration of an authentication system of the present example embodiment will be described using Fig. 1. The authentication system has a monitoring server 10 and an authentication server 20. The authentication system may further have at least one of a monitoring database 30, an authentication database 40, and a power storage system 50. The monitoring server 10 and the authentication server 20 are connected to be communicable in a wired and/or wireless manner. The monitoring server 10 and the power storage system 50 are connected to be communicable in a wired and/or wireless manner.
The monitoring server 10 has a function of monitoring and controlling one or a plurality of power storage systems 50 (a power storage apparatus 51, an output apparatus 52, and an edge device 53). The authentication server 20 has a function of authenticating that the power storage apparatus 51 is healthy. The monitoring database 30 stores various kinds of information processed by the monitoring server 10. The authentication database 40 stores various kinds of information processed by the authentication server 20.
The power storage apparatus 51 is an apparatus that has a function of storing power, and is, for example, a storage battery. The output apparatus 52 is an apparatus that has a function of outputting various kinds of information, and is, for example, a display, a speaker, or a lamp. The edge device 53 has a function of collecting information regarding the power storage system 50 and transmitting information to an external apparatus.

"Outline of Processing of Authentication System"

Next, the outline of processing that is executed by the authentication system will be described. Note that the details of each kind of processing will be described below.

The power storage system 50 performs a diagnostic operation at a predetermined timing and transmits measurement data regarding the power storage apparatus 51 obtained as a result of the diagnostic operation to the monitoring server 10.

The monitoring server 10 acquires the measurement data regarding the power storage apparatus 51 from the edge device 53 and stores the measurement data in the monitoring database 30. In the monitoring database 30, in addition to the measurement data, various other kinds of information (for example, cell capacity in shipment, positive electrode capacity in shipment, negative electrode capacity in shipment, and positive and negative electrode deviation in shipment) regarding the power storage apparatus 51 may be stored. Then, the monitoring server 10 diagnoses a state of health of the power storage apparatus 51 based on the measurement data and the like.

The monitoring server 10 transmits a diagnosis result (hereinafter, simply referred to as "diagnosis result") of the state of health of the power storage apparatus 51 and an application (authentication application) of authentication that the power storage apparatus 51 is healthy to the authentication server 20. The monitoring server 10 may further transmit the measurement data and the like regarding the power storage apparatus 51 and other kinds of information to the authentication server 20.

The authentication server 20 stores various kinds of information received from the monitoring server 10 in the authentication database 40. Then, the authentication server 20 determines whether or not to authenticate that the power storage apparatus 51 is healthy, based on the diagnosis result and transmits a determined authentication result to the monitoring server 10. Note that the authentication server 20 may store the determined authentication result in the authentication database 40.

The monitoring server 10 controls output content of the output apparatus 52 based on the authentication result received from the authentication server 20. Specifically, in a case where the authentication result is " content authenticating that the power storage apparatus 51 is healthy", the monitoring server 10 causes the output apparatus 52 to execute corresponding output processing, and in a case where the authentication result is "content not authenticating that the power storage apparatus 51 is healthy", causes the output apparatus 52 to execute corresponding output processing. For example, display/non-display of an authentication mark that is displayed on the display is switched or a lighting state of the lamp is switched according to the content of the authentication result. Note that the monitoring server 10 may store the received authentication result in the monitoring database 30.

"Flow of Data of Authentication System"

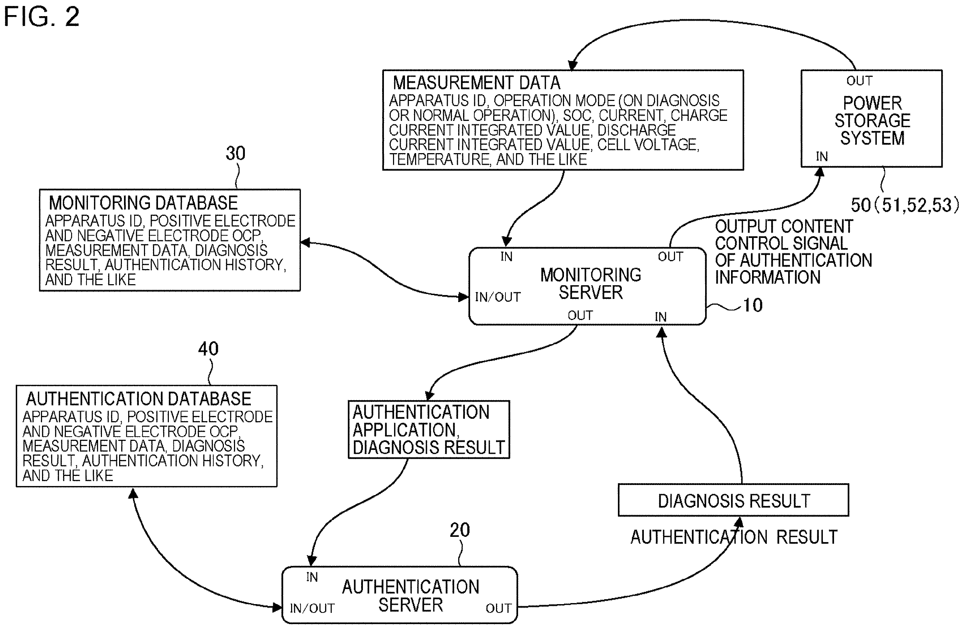

Fig. 2 illustrates a flow of data of the authentication system. As illustrated in the drawing, the measurement data is transmitted from the power storage system 50 to the monitoring server 10. The measurement data is data regarding the power storage apparatus 51, and includes at least one of an apparatus identifier (ID), an operation mode (on diagnosis or normal operation) in measurement, a state of charge (SOC) in measurement, a charge current integrated value in measurement, a discharge current integrated value in measurement, a current, a cell voltage, and a temperature. Note that the measurement data may other item values.

The monitoring server 10 can store the received measurement data in the monitoring database 30. The monitoring server 10 can diagnose the state of health of the power storage apparatus 51 based on the received measurement data and can store the diagnosis result in the monitoring database 30. The monitoring database 30 may store not only latest data (diagnosis result, measurement data) but also past data.

The monitoring server 10 transmits the latest diagnosis result and the authentication application to the authentication server 20. The monitoring server 10 may further transmit the measurement data to the authentication server 20.

The authentication server 20 stores the received information in the authentication database 40. The authentication server 20 determines whether or not to authenticate that the power storage apparatus 51 is healthy, based on the received diagnosis result, stores the determined authentication result in the authentication database 40, and transmits the authentication result to the monitoring server 10. The authentication database 40 may store not only latest data (diagnosis result, measurement data, and authentication result) but also past data (including parameters obtained by computation).

The monitoring server 10 stores the authentication result received from the authentication server 20 in the monitoring database 30. The monitoring database 30 may store not only latest data (authentication result) but also past data. Then, the monitoring server 10 determines the output content in the output apparatus 52 based on the authentication result and transmits a signal for controlling the output content of the output apparatus 52 to the power storage system 50.

"Configuration of Monitoring Server 10"

Next, the configuration of the monitoring server 10 will be described in detail. First, an example of the hardware configuration of the monitoring server 10 will be described. Each functional unit included in the monitoring server 10 is realized by any combination of hardware and software mainly including a central processing unit (CPU), a memory, a program loaded on the memory, a storage unit (can store a program downloaded from a storage medium, such as a compact disc (CD), or a server or the like on the Internet, in addition to a program stored in a stage of shipping the apparatus) that stores the program, such as a hard disk, and an interface for network connection, in any computer. Those skilled in the art can understand that various modifications are made to a realization method and the apparatus.

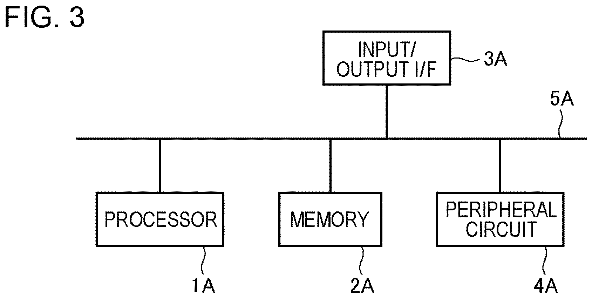

Fig. 3 is a block diagram illustrating the hardware configuration of the monitoring server 10. As illustrated in Fig. 3, the monitoring server 10 has a processor 1A, a memory 2A, an input/output interface 3A, a peripheral circuit 4A, and a bus 5A. The peripheral circuit 4A includes various modules. The monitoring server 10 may not have the peripheral circuit 4A. The monitoring server 10 may be configured with a plurality of physically and/or logically separated apparatuses or may be configured with one physically and/or logically integrated apparatus. When the monitoring server 10 is configured with a plurality of physically and/or logically separated apparatuses, each of the plurality of apparatuses can have the above-described hardware configuration.

The bus 5A is a data transmission path through which the processor 1A, the memory 2A, the peripheral circuit 4A, and the input/output interface 3A transmit and receive data to and from each other. The processor 1A is, for example, an arithmetic processing apparatus, such as a CPU or a graphics processing unit (GPU). The memory 2A is, for example, a memory, such as a random access memory (RAM) or a read only memory (ROM). The input/output interface 3A includes an interface for acquiring information from an input apparatus, an external apparatus, an external server, an external sensor, a camera, and the like, and an interface for outputting information to an output apparatus, an external apparatus, an external server, and the like. The input apparatus is, for example, a keyboard, a mouse, a microphone, a physical button, or a touch panel. The output apparatus is, for example, a display, a speaker, a printer, or a mailer. The processor 1A can issue a command to each module and can perform an arithmetic operation based on a calculation result of each module.

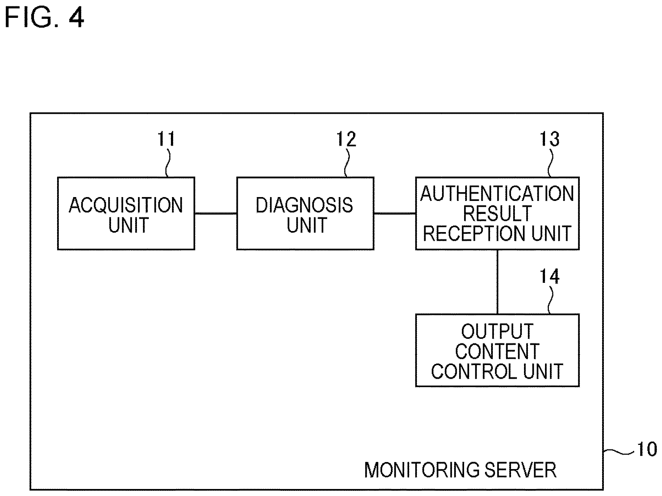

Next, the functional configuration of the monitoring server 10 will be described. Fig. 4 illustrates an example of a functional block diagram of the monitoring server 10. As illustrated in the drawing, the monitoring server 10 has an acquisition unit 11, a diagnosis unit 12, an authentication result reception unit 13, and an output content control unit 14.

The acquisition unit 11 acquires the measurement data regarding the power storage apparatus 51 from the edge device 53. The measurement data regarding the power storage apparatus 51 includes at least one of the apparatus ID for identifying the power storage apparatus 51, the operation mode (on diagnosis or normal operation) in measurement, the SOC in measurement, the charge current integrated value in measurement, the discharge current integrated value in measurement, the current, the cell voltage, and the temperature. Note that the measurement data may other item values.

The power storage system 50 performs the diagnostic operation at a predetermined timing and transmits the measurement data obtained as a result of the diagnostic operation to the measurement data to the monitoring server 10. The acquisition unit 11 acquires the measurement data transmitted from the power storage system 50 in this manner. The predetermined timing may be a timing determined in advance at a time interval determined in advance, such as once a year, once every half a year, or once a month, or may be a timing at which an execution instruction is input from a user or the like.

The diagnosis unit 12 computes various item values for diagnosing the state of health of the power storage apparatus 51 based on the measurement data acquired by the acquisition unit 11. Then, the diagnosis unit 12 diagnoses the state of health of the power storage apparatus 51 based on various computed item values and generates the diagnosis result.

The diagnosis unit 12 can diagnose the state of health of the power storage apparatus 51 using any of the following first to eighth diagnostic methods.

-First Diagnostic Method-

Normally, it is known that a "value obtained by subtracting an open-circuit potential of a negative electrode from an open-circuit potential of a positive electrode" is equal to an "open-circuit voltage". In a case where both values do not match, it is suspected that a measurement sensor of a battery management service (BMS) is abnormal or the power storage apparatus 51 itself is abnormal.

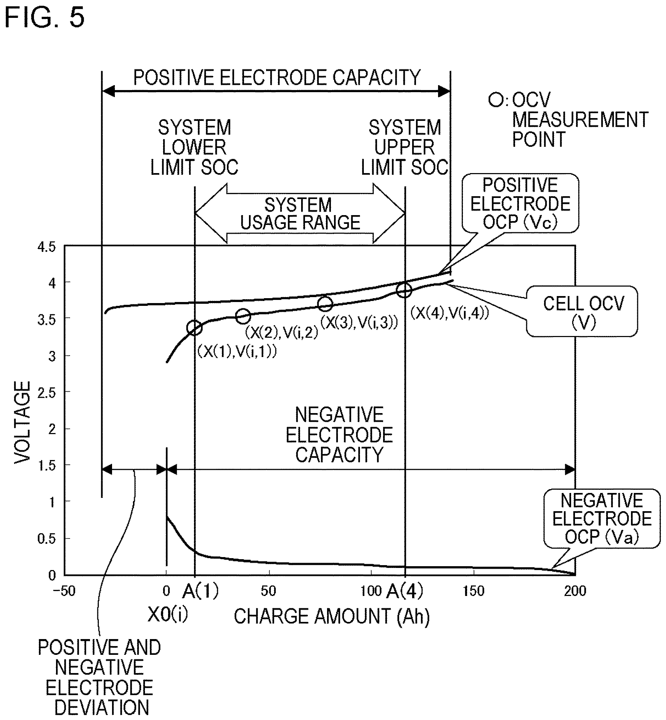

In the first diagnostic method, the diagnosis unit 12 computes "a difference between a reference value (the value obtained by subtracting the open-circuit potential of the negative electrode from the open-circuit potential of the positive electrode) and a measured value of the open-circuit voltage" based on the measurement data acquired by the acquisition unit 11 and determines the state of health of the power storage apparatus 51 based on a computation result. Hereinafter, detailed description will be provided referring to Fig. 5.

Note that a "system usage range" in the drawing is an available range for design of the power storage apparatus 51, and the above-described range is determined by a manufacturer of the power storage apparatus 51 in consideration of safety and the like. The power storage apparatus 51 cannot be charged beyond a system upper limit SOC or cannot be discharged below a system lower limit SOC.

First, in this method, a plurality of times of measurement are performed under conditions in which the SOCs of the power storage apparatus 51 are different. The SOC with which the measurement is executed may be determined in advance (example: 0, 25, 50, 75, and 100), or may be determined through computer processing by any method. In each measurement, the measurement for each of a plurality of cells in the power storage apparatus 51 is performed. The measurement may be performed to all of a plurality of cells in the power storage apparatus 51 or the measurement may be performed to a part of cells.

In the drawing, each measurement timing is indicated by a circle. Then, (X(N),V(i,N)) are associated with each measurement. N is a measurement number (an index indicating a measurement point). i is a cell number. V(i,N) is a cell open-circuit voltage (OCV) measured in the cell of the cell number i. The cell OCV is measured in a state in which charging or discharging is paused for a given time (that is, measured in a state where a charge current is zero) after charging or discharging is performed to a predetermined SOC. In a case where the current is zero, because the cell voltage gradually approaches the cell OCV, charging or discharging may be paused until change in cell voltage disappears. While a pause time is different depending on the capacity or the temperature of the cell, in a case where charging or discharging is paused for about 30 minutes to two hours, the cell OCV can be measured with sufficient accuracy. As apparent from the above description, it is actually difficult to continuously measure the cell OCV, and the measurement of the cell OCV of all of the SOC 0% to 100% requires a long time.

X(N) is an integrated current (a time-integrated value of the current) in measurement of the measurement number N in a battery bank to which the cell of the cell number i belongs. X(N) may be measured with, for example, a coulomb counter or may be obtained by time-integrating a measured value of the current.

Here, a charge amount of the negative electrode of each cell at X(N) is referred to as A(i,N). A(i,N) can be defined as a value obtained by subtracting X0(i) from X(N) (A(i,N) = X(N) - X0(i)). X0(i) is an integrated current when the charge amount of the negative electrode of each cell is zero.

In a case where a positive and negative electrode deviation of the cell i is referred to as B(i), the positive electrode capacity is referred to as Cc(i), and the negative electrode capacity is referred to as Ca(i), "the difference (Ri, N) between the reference value (the value obtained by subtracting the open-circuit potential of the negative electrode from the open-circuit potential of the positive electrode) and the measured value of the open-circuit voltage" in the cell of the cell number i can be defined as represented in Expressions (1) to (3) described below.

$$Sc = (B(i) + A(i,N))/Cc(i) \quad \cdots \quad (1)$$

$$Sa = A(i,N)/Ca(i) \quad \cdots \quad (2)$$

$$R(i,N) = Vc(Sc) - Va(Sa) - V(i,N) \quad \cdots \quad (3)$$

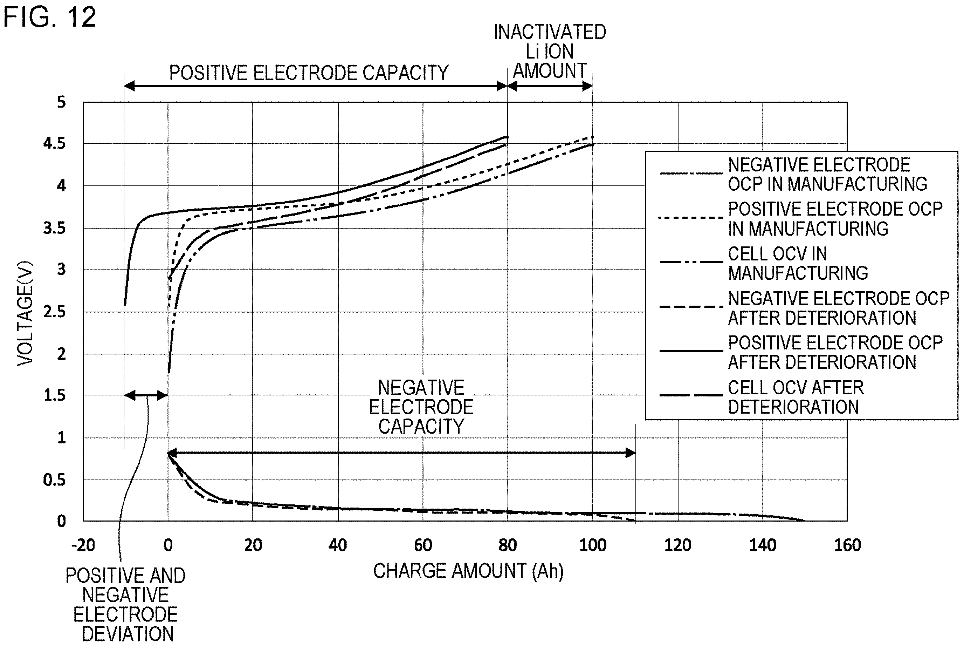

The positive and negative electrode deviation B(i) of the cell i is the difference between a state of charge (charge amount Ah) of the positive electrode at the SOC 0% and a state of charge (charge amount Ah) of the negative electrode at the SOC 0%. As illustrated in Fig. 12, the state of charge of the positive electrode at the SOC 0% and the state of charge of the negative electrode at the SOC 0% in manufacturing (before deterioration) match, and the difference therebetween is zero. However, as illustrated in the drawing, in a case where deterioration occurs, the state of charge of the positive electrode and the state of charge of the negative electrode at the SOC 0% do not match due to capacity deterioration of each of the positive electrode and the negative electrode or inactivation (decrease due to precipitation or turning into a compound) of Li ions.

Vc(Sc) is a function (positive electrode open-circuit potential information) that returns the open-circuit potential of the positive electrode when the state of charge of the positive electrode is Sc. Note that, as represented in Expression (1), the state of charge Sc of the positive electrode is computed based on the positive and negative electrode deviation B(i), the positive electrode capacity Cc(i), and the charge amount A(i,N) of the negative electrode. This function is peculiar to a material for forming the positive electrode and is basically invariable. This function can be obtained by, for example, a pre-measurement experiment.

Va(Sa) is a function (negative electrode open-circuit potential information) that returns the open-circuit potential of the negative electrode when the state of charge of the negative electrode is Sa. Note that, as represented in Expression (2), the state of charge Sa of the negative electrode is computed based on the negative electrode capacity Ca(i) and the charge amount $A(i,N)$ of the negative electrode. This function is peculiar to a material for forming the negative electrode and is basically invariable. This function can be obtained by, for example, a pre-measurement experiment. In general, the pre-measurement experiment is performed by creating a battery for experiment, called a half cell, with Li metal electrodes and electrode materials, and performing charging and discharging. The open-circuit voltages of the positive and negative electrodes may be slightly changed due to the temperature depending on the electrode materials. In this case, the influence of the temperature may be examined in a laboratory in advance, and the temperature influence may be included in the functions $V_c(S_c)$ and $V_a(S_a)$.

$V(i,N)$ is the open-circuit voltage of each measurement of each cell. $V(i,N)$ can be obtained from the measurement data.

Then, variance $J(i)$ of errors in a plurality of times of measurement can be defined as Expression (4) described below. n is the number of times of measurement.

$$J(i) = \sum_{N=1}^{n} (R(i,N))^2 \quad \cdots \quad (4)$$

From the above expressions and the definition of "$A(i,N)=X(N)-X0(i)$", the variance $J(i)$ of errors becomes a function in which $X0(i)$, $B(i)$, $Cc(i)$, and $Ca(i)$ are unknowns. The diagnosis unit 12 obtains the values of $X0(i)$, $B(i)$, $Cc(i)$, and $Ca(i)$ at which the variance $J(i)$ of errors is minimized, based on this function and the measurement data of at least four times of measurement. Then, the value of the variance $J(i)$ of errors at this moment (when the variance $J(i)$ of errors is minimized) is referred to as a cell-specific evaluation value. The cell-specific evaluation value is a sum of squares of item values ($R(i,N)$) of each of a plurality of times of measurement of each cell.

The diagnosis unit 12 can compute a sum of the cell-specific evaluation values of a plurality of cells as an evaluation value SR of the power storage apparatus 51 based on Expression (5) described below. m is the number of cells to be processed.

$$SR = \sum_{i=1}^{m} (J(i)) \quad \cdots \quad (5)$$

Then, the diagnosis unit 12 diagnoses the state of health of the power storage apparatus 51 based on at least one of the cell-specific evaluation values and the evaluation value of the power storage apparatus 51. The state of health can be determined even with the fact that there is no statistical outlier in $J(i)$ of each cell computed from a measurement result. The presence of the outlier means that there are several abnormal cells in the system. A need or the like for maintenance can be determined based on this information. Note that the absence of the outlier can be determined by performing, for example, a Smirnoff-Grubbs test.

For example, the diagnosis unit 12 may determine that the power storage apparatus 51 is healthy, in a case where one condition of "all cell-specific evaluation values are equal to or less than a first standard value", "a predetermined proportion or more of cell-specific evaluation values are equal to or less than the first standard value", and "the evaluation value of the power storage apparatus 51 is equal to or less than a second standard value" or a condition obtained by connecting a plurality of conditions among the above-described conditions with a logical operator is satisfied.

This diagnostic method is usable, for example, in a case where the positive electrode is NMC and the negative electrode is graphite or HC. Note that the illustration is merely an example, and the present invention is not limited thereto. Because a voltage peculiar to a material with respect to the state of charge of the material is used in this diagnostic method, combinations of the positive electrode and the negative electrode other than that illustrated herein can also be applied.

-Second Diagnostic Method-

In the second diagnostic method, similarly to the first diagnostic method, the diagnosis unit 12 computes "the difference between the reference value (the value obtained by subtracting the open-circuit potential of the negative electrode from the open-circuit potential of the positive electrode) and the measured value of the open-circuit voltage" based on the measurement data acquired by the acquisition unit 11 and determines the state of health of the power storage apparatus 51 based on a computation result.

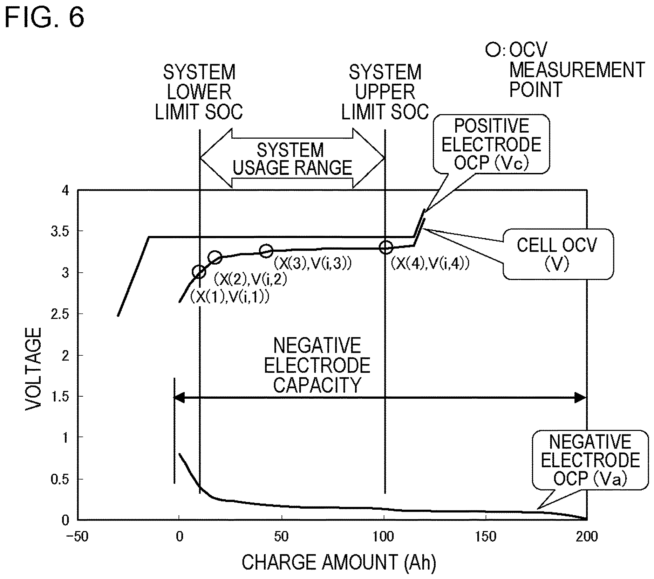

By the way, in a case where $LiFePO_4$ is used as the positive electrode, the power storage apparatus 51 is used only in a range in which the voltage is flat as illustrated in Fig. 6. Thus, a position of the positive electrode ($LiFePO_4$) in

a lateral axis direction of the drawing cannot be known from an OCV in a measurement range. Accordingly, in this method, on an assumption that a positive electrode voltage is constant, diagnosis is performed by the same method as in the first diagnostic method. Specifically, Sc in Expression (3) is a fixed value. As a result, the variance J(i) of errors becomes a function in which X0(i) and Ca(i) are unknowns. Because the unknowns are two points, the variance J(i) of errors is computed based on the measurement data of at least three times of measurement and the evaluation value SR is obtained to perform diagnosis. Here, similarly to the above description, the state of health can be determined even with the fact that there is no statistical outlier in J(i) of each cell.

This diagnostic method can be used, for example, in a case where the positive electrode is $LiFePO_4$ and the negative electrode is graphite or HC. Note that the illustration is merely an example, and the present invention is not limited thereto.

-Third Diagnostic Method-

In a cell of a combination of LiFePO4 and graphite, a voltage hysteresis in the OCV is relatively large, and diagnosis accuracy is likely to be deteriorated. The voltage hysteresis of the OCV described herein indicates that values of an OCV (an OCV in a charging direction) measured after temporarily stopping charging during charging and leaving until the voltage is constant and an OCV (an OCV in a discharging direction) measured after leaving until discharging is temporarily stopped during discharging to make the voltage constant do not match. The mismatch between the OCV in the charging direction and the OCV in the discharging direction is called the voltage hysteresis of the OCV. The voltage hysteresis is a maximum of about 20 mV in a case of graphite. In a case where LiFePO4 is the positive electrode, the positive electrode voltage is substantially constant. Thus, in a case where the voltage hysteresis is not considered, a diagnosis error expands.

The voltage hysteresis can be obtained by measuring a voltage on leaving until the voltage is not changed after discharging or charging from a state of charge or discharge to be a reference by a predetermined amount. The OCP of the electrode materials and an OCV of a battery voltage can be measured in advance after stopping charging or discharging as appropriate during charging or discharging and leaving until change in voltage disappears. Then, a value in the charging direction and a value in the discharging direction are individually present for each of the positive electrode OCP, the negative electrode OCV, and the battery voltage OCV. (See Non-Patent Documents 2 and 3).

In a case where the OCV is measured after stopping charging immediately after charging starts when discharging is not completed (for example, the SOC 25%), for example, at the SOC 30% and leaving until the voltage is not changed, the measured OCV is an intermediate value of the OCV in the discharging direction and the OCV in the charging direction at the SOC 30% measured immediately after charging starts when discharging is completed (see Non-Patent Document 3). Thus, in a case where the first diagnostic method described above is carried out using the OCV at the SOC 30% measured immediately after charging starts when discharging is not completed (for example, the SOC 25%) without change, there is a concern that a large diagnosis error occurs. The third diagnostic method includes a configuration for solving this problem.

In the third diagnostic method, as described in the first diagnostic method, a plurality of times of measurement are performed under conditions in which the SOCs of the power storage apparatus 51 are different. Then, in the third diagnostic method, determination regarding whether each measurement matches measurement in the charging direction or measurement in the discharging direction is performed. For example, it is assumed that transition of the SOC of the measurement timing is made in an order of " 10% → 90% → 75% → 65% → 30% → 10%". In this case, the measurement at the SOC 10%, 30%, 65%, and 75% is the measurement in the discharging direction, and the OCV measured at this moment is an OCV in discharging. Then, the measurement at the SOC 90% is the measurement in the charging direction, and the OCV measured at this moment is the OCV in charging.

Then, in the third diagnostic method, for an electrode material having a hysteresis, each of the positive electrode OCP and the negative electrode OCP in measurement in the charging direction, and the positive electrode OCP and the negative electrode OCP in measurement in the discharging direction is obtained in advance. These can be measured in advance using a half cell made of a Li electrode and an electrode material, for example. Then, in the third diagnostic method, for computation of R(i,N) using Expression (3) described above, "the positive electrode OCP and the negative electrode OCP in measurement in the charging direction" measured in advance are used in the measurement time in the charging direction, and "the positive electrode OCP and the negative electrode OCP in measurement in the discharging direction" measured in advance are used in the measurement time in the discharging direction. That is, the values of the positive electrode OCP and the negative electrode OCP for use in computation of R(i,N) are varied according to whether the measurement time is the measurement time in the charging direction or the measurement time in the discharging direction. Other configurations of the third diagnostic method are the same as those of the first diagnostic method.

Note that details of a measurement timing (SOC transition) of a battery having a large hysteresis may be determined as follows. A charging direction cell OCV is measured from the SOC 0% in units of, for example, 5% in advance, and next, a discharging direction OCV is measured from the SOC 100% in units of, for example, 5%. Next, in a case where the SOC where an operation is actually possible is from 20% to 80%, the OCV is measured from 20% in units of 5% and is compared with the charging direction OCV value measured in advance, and the SOC (for example, the SOC where the difference between both values is equal to or less than the measurement accuracy of a voltage measurement IC + $\alpha$) where both values begin to match with sufficient accuracy is obtained (for example, it is assumed that the value of the SOC is 70%). Even in the discharging direction, discharging is started after charging is performed to the SOC 80%, the OCV is measured similarly and is compared with the discharging direction OCV value measured in advance, and the SOC (for example, the SOC where the difference between both values is equal to or less than the measurement accuracy of the voltage measurement IC + $\alpha$) where both values begin to match with sufficient accuracy is obtained (for example, it is assumed that the value of the SOC is 60%). Based on this result, the measurement timing (SOC transition) can be determined in an order of SOC 20% → 70% → 80% → 60% → 30% → 20%.

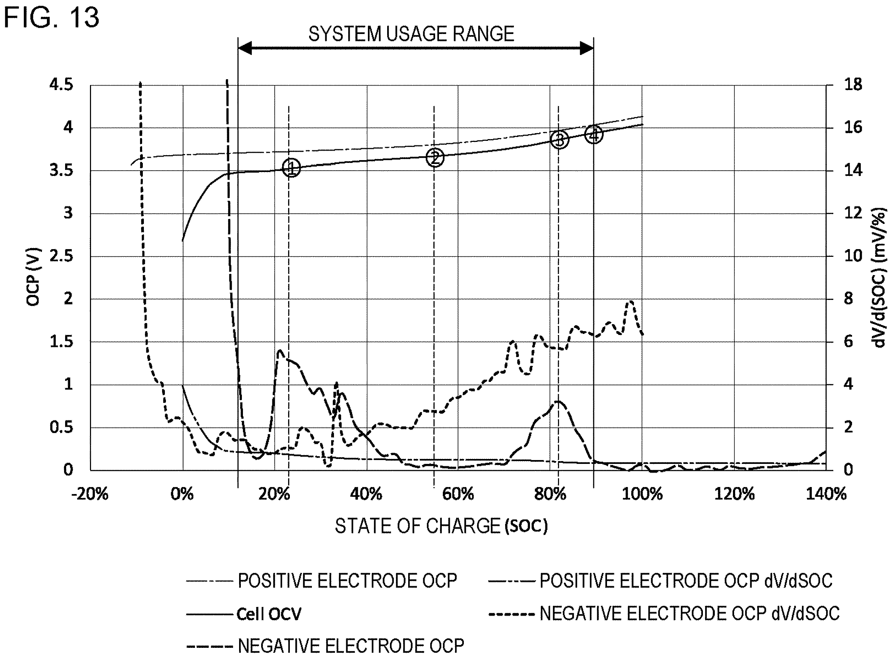

It is preferable that a point where a voltage slope with respect to the state of charge (SOC) of the positive and negative electrodes is large is selected and measurement is performed. Fig. 13 illustrates the OCP of the positive and negative electrodes and a voltage slope dV/dSOC with respect to the state of charge of the OCP of the positive and negative electrodes, and a battery OCV. In measuring the positive electrode capacity and the negative electrode capacity with high accuracy with measurement at several points, measurement may be performed at a point where the slope of the voltage of each of the positive and negative electrodes with respect to the state of charge is large. In a case where measurement is performed in a region where the voltage slope is small, errors in capacity of the positive and negative electrodes become large. With the resolution Vres and the accuracy Vacu of cell voltage measurement, the resolution of Sc and Sa of Expressions (1) to (3) is Vres/((dV/dSOC)), and similarly, the accuracy of Sc and Sa is Vacu/((dV/dSOC)), with respect to the slope dV/dSOC of the positive and negative electrode OCP. For example, in a case where the measurement resolution of a cell voltage measurement IC that is used in a battery system is 1 mV, measurement accuracy is $\pm 1$ mV, and the slope of the OCV is measured at a point of 2 mV/%, the resolution of Sa and Sc is 0.5% with respect to the cell capacity, the accuracy is $\pm 0.5$%, and sufficient measurement accuracy for practical use is obtained.

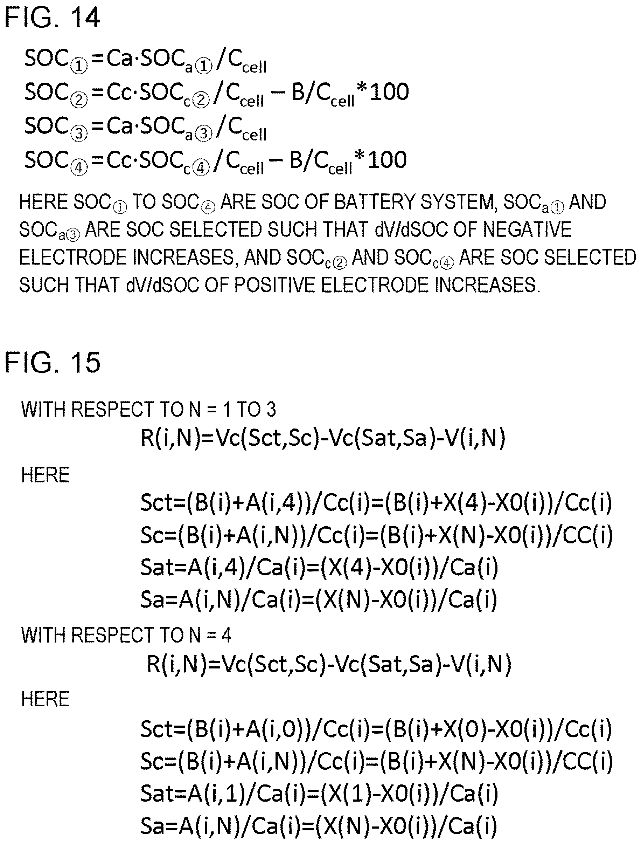

For example, two points or more where dV/dSOC of an OCP curve of each of the positive and negative electrodes is large are selected as measurement points. In an example of Fig. 14, (1) and (3) are selected from a region where dV/dSOC of the negative electrode is large, and (2) and (4) are selected from a region where dV/dSOC of the positive electrode is large. Positive and negative electrode deviation B, a cell capacity Ccell, and positive and negative electrode capacities Cc and Ca of a cell in a new product state are measured in a laboratory at a cell level before monitoring begins, and the SOC of the measurement points (1) to (4) can be determined based on a condition represented in Fig. 14, for example. An electric storage system manages a battery system with a SOC, and can give a target SOC and can cause the battery system to perform charging and discharging such that a system SOC reaches a target value.

Note that measured values of B, Ccell, Cc, and Ca in previous diagnosis may be used from second diagnosis, and the SOC of the measurement points (1) to (4) may be determined based on the condition represented in Fig. 14, for example. Because a lot of cells are used in an actual system, in regard to B, Ccell, Cc, Ca, statistics (average value, maximum value, minimum value, mode, median value, and the like) of measured values of a plurality of cells of each system can be used.

A configuration is made in which, even though the battery is deteriorated and the positive and negative electrode capacities and the positive and negative electrode deviation are changed, the measurement point of the cell is computed by computation, so that accurate diagnosis can be carried out even after deterioration. Even in a case where there is no data of the laboratory, in a case where the electrode materials are known, the OC of the materials are known. Thus, it is possible to determine a target measurement SOC of each of the positive and negative electrodes based on the known values, and to improve diagnosis accuracy after repeating diagnosis many times.

By the way, an OCV curve (for example, OCV measured values at SOC: 0, 10, 20, ..., 90, and 100%) suitably measured during charging from a standard state of the SOC 0% and an OCV curve (for example, OCV measured values at the SOC: 20, ..., 90, and 100%) measured during charging from the SOC 20% after discharging to the SOC 20% may not match with sufficient accuracy depending on the electrode materials or electrode design of the battery. In such a case, it is preferable that diagnosis is performed using a voltage (or the reverse) in a transition state from an OCV during discharging to an OCV during charging. In such a case, the state of charge Set and Sat of the positive and negative electrodes are passed as arguments to the computation functions of the positive and negative electrode OCP, that is, Vc(Sct,Sc) and Va(Sat,Sc) may be computed as described below.

For example, it is assumed that the cell OCV measurement of the diagnostic operation is carried out with the SOC 10%, 20%, 60%, and 90%. In this case, the diagnostic operation is performed, for example, in such a manner that X(0) is measured with the SOC 10% (the OCV may not be measured), then, (X(4),V(i,4)) is measured with the SOC 90%, then, (X(3),V(i,3)) is measured with the SOC 60%, then, (X(2),V(i,2)) is measured with the SOC 20%, and then, (X(1),V(i,1)) is measured with the SOC 10%. Because the measurement is performed in an order of the SOC 10% → 90% → 60% → 20% → 10%, (X(4),V(i,4)) of the measurement with the SOC 90% is a measured value in the charging direction, and (X(3),V(i,3)), (X(2),V(i,2)), and (X(1),V(i,1)) of the measurement with the SOC 60%, 20%, and 10% are measured values in the discharging direction.

The arithmetic operation of Expression (3) described above is performed with respect to the measured values as illustrated in Fig. 15. The functions Vc and Va may be measured in advance in a laboratory or the like and approximates may be obtained or may be obtained with the method illustrated in Non-Patent Document 3.

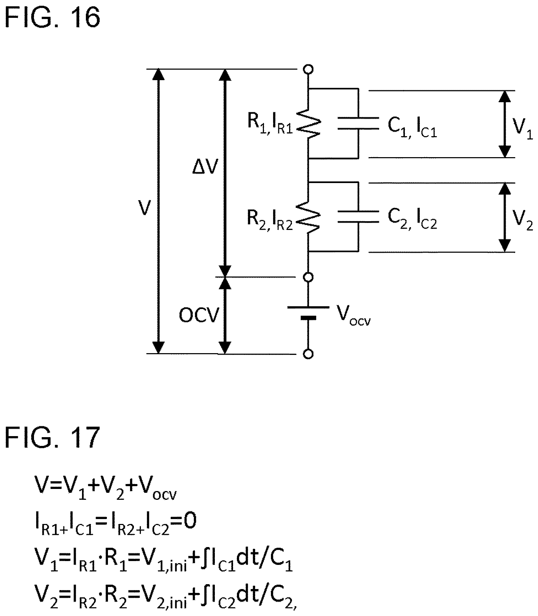

By the way, while the OCV is a voltage that is obtained by measurement after waiting until the voltage is not changed after the current for charging or discharging is stopped, a waiting time may be about two hours depending on the type of battery. Determination regarding whether or not the battery voltage converges may also be continued for a long time in a case where voltage change is very slow (for example, 1 mV/10 minutes is continued for one hour), and the determination is difficult. It is known that transient change in voltage of the battery can be expressed with a circuit shown in Fig. 16. In the drawing, Vocv is the OCV of the cell, Visa measured voltage, $\Delta V$ is transient voltage change, R1 and R2 are resistance values, IR1 and IR2 are currents flowing in resistors, C1 and C2 are capacitor capacitance, IC1 and IC2 are currents flowing in the capacitors, and V1 and V2 are voltages applied to the resistors and the capacitors.

Accordingly, for example, a voltage after charge and discharge currents are zero may be computed using the expression represented in Fig. 17. In this case, the OCV can be obtained in a practical measurement time (for example, about 30 minutes). In a relational expression of Fig. 17, initial values V1,ini and V2,ini of V1 and V2, R1, R2, C1, C2, and Vocv can be obtained to conform to change in voltage V measured before the voltage completely converges. Because the number of independent variables is seven, computation can be performed from seven or more measurement points. While a more complicated circuit model for increasing accuracy of fitting has been published in papers and the like, the circuit illustrated in Fig. 16 is sufficiently used for practical use.

-Fourth Diagnostic Method-

In the fourth diagnostic method, similarly to the first diagnostic method, the diagnosis unit 12 computes "the difference between the reference value (the value obtained by subtracting the open-circuit potential of the negative electrode from the open-circuit potential of the positive electrode) and the measured value of the open-circuit voltage" based on the measurement data acquired by the acquisition unit 11, and determines the state of health of the power storage apparatus 51 based on a computation result. However, the fourth diagnostic method is different from the first diagnostic method in terms of a method of obtaining X0(i), B(i), Cc(i), and Ca(i).

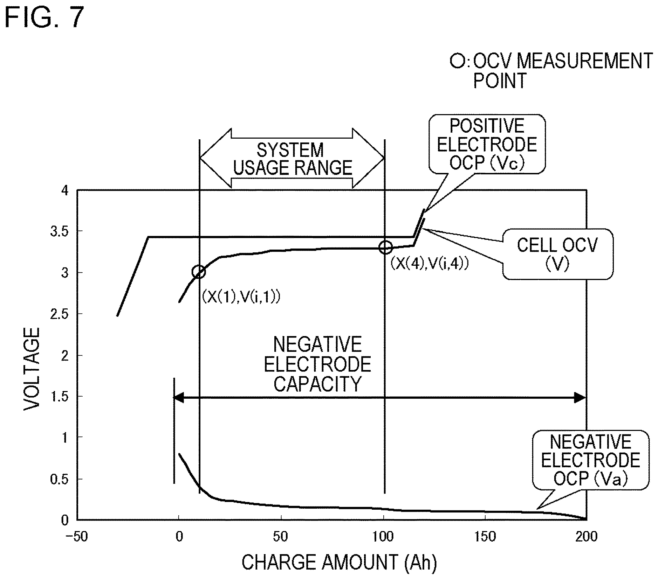

Specifically, in this diagnostic method, as illustrated in Fig. 7, measurement is performed with the lower limit SOC of the system usage range, and thereafter, charging is performed to the upper limit SOC and measurement is performed again. Then, charge current and voltage in measurement during the period are measured. Note that the measurement range is not always between the lower limit SOC and the upper limit SOC, but in a case where the measurement range is set in this manner, accuracy is increased.

The diagnosis unit 12 obtains X0(i), B(i), Cc(i), and Ca(i) based on measurement data of the above-described charge current and voltage in measurement by the method disclosed in Non-Patent Document 1. Then, the diagnosis unit 12 can compute the state of charge Sc of the positive electrode, the state of charge Sa of the negative electrode, the difference R(i,N) between the reference value and the measured value of the open-circuit voltage, the cell-specific evaluation value (the variance J(i) of errors), the evaluation value SR of the power storage apparatus 51, and the like based on the obtained values and Expressions (1) to (5) described above. Similarly to the above description, the state of health can be determined even from the fact that there is no statistical outlier in X0(i), B(i), Cc(i), and Ca(i) of each cell.

This diagnostic method has no restriction to the materials of the positive electrode and the negative electrode, and is usable for the positive electrodes and the negative electrodes formed of any materials.

-Fifth Diagnostic Method-

In the fifth diagnostic method, the diagnosis unit 12 computes "the positive electrode capacity Cc(i) and the negative electrode capacity Ca(i)" based on the measurement data acquired by the acquisition unit 11 and determines the state of health of the power storage apparatus 51 based on a computation result. Hereinafter, details will be described.

The diagnosis unit 12 computes "the positive electrode capacity Cc(i) and the negative electrode capacity Ca(i)" for each cell i based on the measurement data acquired by the acquisition unit 11 and sets the values as the cell-specific evaluation value. The computation of the positive electrode capacity Cc(i) and the negative electrode capacity Ca(i) can be realized by the method described in the first to fourth diagnostic methods, for example.

The diagnosis unit 12 can compute an evaluation value SRc of the positive electrode and the evaluation value SRa of the negative electrode of the power storage apparatus 51 based on Expressions (6) and (7) described below. Ccave is an average value of Cc(i) of the cells included in the system. Caave is an average value of Ca(i) of a plurality of cells included in the system.

$$SRc = \sum_{i=1}^{m} (Cc(i) - Ccave)^2 \quad \cdots \quad (6)$$

$$SRa = \sum_{i=1}^{m} (Ca(i) - Caave)^2 \quad \cdots \quad (7)$$

Then, the diagnosis unit 12 diagnoses the state of health of the power storage apparatus 51 based on at least one of the cell-specific evaluation values, the evaluation value of the positive electrode of the power storage apparatus 51, and the evaluation value of the negative electrode of the power storage apparatus 51.

For example, the diagnosis unit 12 may determine that the power storage apparatus 51 is healthy, in a case where one condition of "all cell-specific evaluation values are equal to or less than a third standard value", "a predetermined proportion or more of cell-specific evaluation values are equal to or less than the third standard value", "the evaluation value of the positive electrode of the power storage apparatus 51 is equal to or less than a fourth standard value", and "the evaluation value of the negative electrode of the power storage apparatus 51 is equal to or less than a fifth standard value" or a condition obtained by connecting a plurality of conditions among the above-described conditions with a logical operator is satisfied. Similarly to the above description, the state of health can be determined even from the fact that there is no statistical outlier in Cc(i) and Ca(i) of each cell.

-Sixth Diagnostic Method-

In the sixth diagnostic method, the diagnosis unit 12 computes the "positive and negative electrode deviation B(i)" based on the measurement data acquired by the acquisition unit 11 and determines the state of health of the power storage apparatus 51 based on a computation result. Hereinafter, details will be described.

The diagnosis unit 12 computes the "positive and negative electrode deviation B(i) for each cell i based on the measurement data acquired by the acquisition unit 11 and sets the value as the cell-specific evaluation value. The computation of the positive and negative electrode deviation B(i) can be realized by the method described in the first to fourth diagnostic methods described above, for example.

The diagnosis unit 12 can compute an evaluation value RB of the power storage apparatus 51 based on Expression (8) described below. Bave is an average value of B(i) of a plurality of cells included in the system.

$$RB = \sum_{i=1}^{m} (B(i) - Bave)^2 \quad \cdots \quad (8)$$

Then, the diagnosis unit 12 diagnoses the state of health of the power storage apparatus 51 based on at least one of the cell-specific evaluation value and the evaluation value of the power storage apparatus 51.

For example, the diagnosis unit 12 may determine that the power storage apparatus 51 is healthy, in a case where one condition of "all cell-specific evaluation values are equal to or less than a sixth standard value", "a predetermined proportion or more of cell-specific evaluation values are equal to or less than the sixth standard value", and "the evaluation value of the power storage apparatus 51 is equal to or less than a seventh standard value" or a condition obtained by connecting a plurality of conditions among the above-described conditions with a logical operator is satisfied.

-Seventh Diagnostic Method-

In the seventh diagnostic method, the diagnosis unit 12 computes a "negative electrode utilization factor Aar(i)" based on the measurement data acquired by the acquisition unit 11 and determines the state of health of the power storage apparatus 51 based on a computation result. Hereinafter, details will be described.

The diagnosis unit 12 computes the "negative electrode utilization factor Aar(i)" for each cell i based on the measurement data acquired by the acquisition unit 11 and sets the value as the cell-specific evaluation value. The negative electrode utilization factor Aar(i) is defined by Expressions (9) and (10) described below.

$$Cab = X(i, Socmax) - X(i, Socmin) \quad \cdots \quad (9)$$

$$Aar(i) = Cab(i)/Ca(i) \quad \cdots \quad (10)$$

Socmax is a SOC of a system usage range upper limit. Socmin is a SOC of a system usage range lower limit. X(i,socmax) is an integrated current in measurement in a state where the SOC in the battery bank to which the cell of the cell number i belongs is the system usage range upper limit, and can be measured by charging the system to the upper limit SOC. X(i,socmin) is an integrated current in measurement in a state where the SOC in the battery bank to which the cell of the cell number i belongs is the system usage range lower limit, and can be measured by discharging the system to the lower limit SOC.

The diagnosis unit 12 can compute an evaluation value SRAar of the power storage apparatus 51 based on Expression (11) described below. Aarave is an average value of Ar(i) of a plurality of cells included in the system.

$$SRAar = \sum_{i=1}^{m} (Aar(i) - Aarave)^2 \quad \cdots \quad (11)$$

Then, the diagnosis unit 12 diagnoses the state of health of the power storage apparatus 51 based on at least one of the cell-specific evaluation value and the evaluation value of the power storage apparatus 51.

For example, the diagnosis unit 12 may determine that the power storage apparatus 51 is healthy, in a case where one of "all cell-specific evaluation values are equal to or less than an eighth standard value", "a predetermined proportion or more of cell-specific evaluation values are equal to or less than the eighth standard value", and "the evaluation value of the power storage apparatus 51 is equal to or less than a ninth standard value" or a condition obtained by connecting a plurality of conditions among the above-described conditions with a logical operator is satisfied. Note that, as the negative electrode utilization factor is lower, lithium precipitation is less likely to occur, and safety is secured.

-Eighth Diagnostic Method-

In the eighth diagnostic method, the diagnosis unit 12 computes "a negative electrode SOC (Soca(i)) at the upper limit SOC" based on the measurement data acquired by the acquisition unit 11 and determines the state of health of the power storage apparatus 51 based on a computation result. Hereinafter, details will be described.

The upper limit SOC is the SOC of the system usage range upper limit. The diagnosis unit 12 computes "the negative electrode SOC (Soca(i)) at the upper limit SOC" based on the measurement data acquired by the acquisition unit 11 for each cell i and sets the value as the cell-specific evaluation value. The negative electrode SOC (Soca(i)) at the upper limit SOC is defined by Expression (12) described below. A(i,socmax) is a value obtained by subtracting X0(i) from X(i,socmax). X(i,socmax) may be measured by performing charging to the SOC upper limit of the system in measurement. Alternatively, X(i,socmax) may be obtained by computation based on information regarding the SOC or capacity displayed on the system and X0(i).

$$Soca(i) = A(i,Socmax)/Ca(i) \quad \cdots \quad (12)$$

The diagnosis unit 12 can compute the evaluation value SRSoca of the power storage apparatus 51 based on Expression (13) described below. Socaave is an average value of Soca(i) of a plurality of cells included in the system.

$$SRSoca = \sum_{i=1}^{m} (A(i,Socmax)/Ca(i) - Socaave)^2 \quad \cdots \quad (13)$$

Then, the diagnosis unit 12 diagnoses the state of health of the power storage apparatus 51 based on at least one of the cell-specific evaluation value and the evaluation value of the power storage apparatus 51.

For example, the diagnosis unit 12 may determine that the power storage apparatus 51 is healthy, in a case where one condition of "all cell-specific evaluation values are equal to or less than a tenth standard value", "a predetermined proportion or more of cell-specific evaluation values are equal to or less than the tenth standard value", and "the evaluation value of the power storage apparatus 51 is equal to or less than an eleventh standard value" or a condition obtained by connecting a plurality of conditions among the above-described conditions with a logical operator is satisfied.

-Ninth Diagnostic Method-

In the ninth diagnostic method, the diagnosis unit 12 computes "an inactivated content $Li_{Li}(i)$ of lithium ions" based on the measurement data acquired by the acquisition unit 11 and determines the state of health of the power storage apparatus 51 based on a computation result. Hereinafter, details will be described.

The inactivated content $Li_{Li}(i)$ of lithium ions can be determined as Expression (14) described below using the positive and negative electrode deviation B(i) of the cell i and a deterioration amount Lca(i) after manufacturing of the positive electrode.

$$L_{Li}(i) = B(i) - L_{Ca}(i) \cdots \quad (14)$$

In a case where a positive electrode capacity in shipment is Caimi, Lca(i) can be defined as Expression (15) described below.

$$L_{Ca}(i) = Caimi(i) - Ca(i) \quad \cdots \quad (15)$$

Then, from Expression (14) and Expression (15), the inactivated content $Li_{Li}(i)$ of lithium ions can be defined as follows. The inactivated content $Li_{Li}(i)$ of lithium ions can be obtained using this expression.

$$L_{Li}(i) = B(i) - (Caimi(i) - Ca(i)) \quad \cdots \quad (16)$$

Then, the evaluation value is computed by Expression (17) described below, and $L_{Liave}$ that may be used to evaluate the state of health is an average value of $Li_{Li}(i)$ of a plurality of cells included in the system. Similarly to the above description, the state of health can be determined even from the fact that there is no statistical outlier in $Li_{Li}(i)$ of each cell.

$$SR = \sum_{i=1}^{m} (L_{Li}(i) - L_{Li}ave) \quad \cdots \quad (17)$$

-Tenth Diagnostic Method-

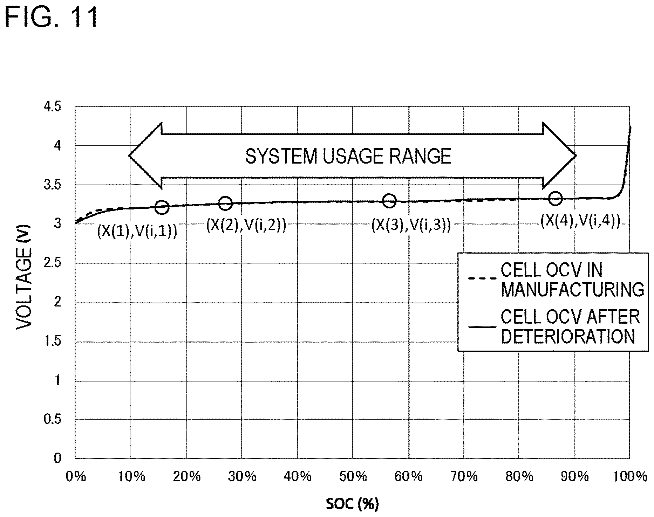

In the combination of $LiFePO_4$ and graphite, a difference between a cell OCV curve in manufacturing and a cell OCV curve in a case where an aging operation is performed is extremely small in a case where the cell is normal. Conversely, an abnormality appears in the cell OCV curve only when a material abnormality occurs in the positive electrode or the negative electrode. Thus, as illustrated in Fig. 11, determination can be performed even by a method that does not separately compute the positive electrode and the negative electrode and compares a directly measured value with the cell OCV curve in manufacturing.

The diagnosis unit 12 obtains X0(i) and Ccell(i) for each cell such that J(i) defined by Expressions (18) and (20) described below is minimized.

$$A(i,N) = X(N) - X0(i) \quad \cdots \quad (18)$$

$$R'(i,N) = Vcell(A(i,N)/Ccell(i)) - V(i,N) \quad \cdots \quad (19)$$

$$J(i) = \sum_{N=1}^{n} (R'(i,N))^2 \quad \cdots \quad (20)$$

Here, N is a measurement number (an index indicating a measurement point). Ccell(i) is the capacity of each cell, and Vcell(SOC) is a function that returns a voltage with respect to a SOC given in manufacturing. The evaluation value SR in the battery system can be obtained from the above-described value J(i), and the determination can be performed. Similarly to the above description, the state of health can be determined even from the fact that there is no statistical outlier in J(i) of each cell.

-Eleventh Diagnostic Method-

The eleventh diagnostic method employs at least two of the first to tenth diagnostic methods. Then, the diagnosis unit 12 diagnoses that the power storage apparatus 51 is healthy, in a case where determination is made to be healthy in all employed diagnostic methods.

As described above, the diagnosis unit 12 can diagnose the state of health of the power storage apparatus 51 based on at least one item value of "the difference between the reference value (the value obtained by subtracting the open-circuit potential of the negative electrode from the open-circuit potential of the positive electrode) and the measured value of the open-circuit voltage", "the positive electrode capacity", "the negative electrode capacity", "the positive and negative electrode deviation", "the inactivated Li ion content", "the negative electrode utilization factor", and "the negative electrode SOC at the upper limit SOC".

The diagnosis unit 12 can compute at least one item value of "the difference between the reference value and the measured value of the open-circuit voltage", "the positive electrode capacity", "the negative electrode capacity", "the positive and negative electrode deviation", "the inactivated Li ion content", "the negative electrode utilization factor", and "the negative electrode SOC at the upper limit SOC" for each of a plurality of cells (all cells or a part of cells in the power storage apparatus 51) in the power storage apparatus 51. Then, the diagnosis unit 12 can diagnose the state of health of the power storage apparatus 51 based on at least one of "the comparison result of the item value in each of a plurality of cells with the first standard value" and "the comparison result of the variance of the item values in a plurality of cells with the second standard value".

The diagnosis unit 12 can diagnose the state of health based on the presence or absence of an outlier in a parameter measured for each cell.

Returning to Fig. 4, the authentication result reception unit 13 transmits the diagnosis result of the diagnosis unit 12 and the authentication application to the authentication server 20. Then, the authentication result reception unit 13 receives the authentication result based on the diagnosis result as a reply from the authentication server 20. The authentication result indicates "whether or not to authenticate that the power storage apparatus 51 is healthy".

The output content control unit 14 controls the output content of the authentication information output from the output apparatus 52, based on the authentication result received by the authentication result reception unit 13.

For example, the output apparatus 52 may be the display, and the authentication information may be the authentication mark. Then, the output content control unit 14 may switch between display/non-display of the authentication mark according to the authentication result. For example, the output content control unit 14 may cause the display to display the authentication mark in a case where the authentication result is "the content authenticating that the power storage apparatus 51 is healthy", and brings the authentication mark on the display into non-display in a case where the authentication result is "the content not authenticating that the power storage apparatus 51 is healthy".

In addition, the output apparatus 52 may be the lamp, and the authentication information may be the lighting state of the lamp. Then, the output content control unit 14 may switch the lighting state of the lamp according to the authentication result. For example, the output content control unit 14 may light the lamp in a case where the authentication result is "the content authenticating that the power storage apparatus 51 is healthy" and may make the lamp non-lighting in a case where the authentication result is "the content not authenticating that the power storage apparatus 51 is healthy", or vice versa. In addition, the output content control unit 14 may vary the color of the lamp or may vary the aspect (blinking, full-time lighting, or the like) of lighting according to the authentication result.

In addition, the output apparatus 52 may be the speaker, and the authentication information may be warning sound or warning information output from the speaker. Then, the output content control unit 14 may switch an output state of the warning sound or the warning information according to the authentication result. For example, the output content control unit 14 may not output the warning sound or the warning information in a case where the authentication result is "the content authenticating that the power storage apparatus 51 is healthy" and may output the warning sound or the warning information in a case where the authentication result is "the content not authenticating that the power storage apparatus 51 is healthy".

"Configuration of Authentication Server 20"

An example of the hardware configuration of the authentication server 20 is illustrated in Fig. 3 similarly to the monitoring server 10. As illustrated in Fig. 3, the authentication server 20 has a processor 1A, a memory 2A, an input/output interface 3A, a peripheral circuit 4A, and a bus 5A. The peripheral circuit 4A includes various modules. The authentication server 20 may not have the peripheral circuit 4A. The authentication server 20 be configured with a plurality of physically and/or logically separated apparatuses or may be configured with one physically and/or logically integrated apparatus. In a case where the authentication server 20 is configured with a plurality of physically and/or logically separated apparatuses, each of the plurality of apparatuses can have the above-described hardware configuration. Note that the detailed description of Fig. 3 is described above, and thus, description will not be repeated here.

Next, the functional configuration of the authentication server 20 will be described. In a case where the diagnosis result and the authentication application are received from the monitoring server 10, the authentication server 20 determines whether or not to authenticate that the power storage apparatus 51 is healthy, based on the received diagnosis result. Then, the authentication server 20 transmits a determined authentication result to the monitoring server 10.

While the content of processing of determining whether or not to authenticate to be healthy is a design matter, determination may be made to authenticate to be healthy, for example, in a case where the authentication server 20 satisfies a predetermined authentication condition. The predetermined authentication condition is, not limited to, "the diagnosis result of the monitoring server 10 indicates health", "the diagnosis result and the authentication application received from the monitoring server 10 are valid", or the like. As a determination method of validity of the diagnosis result and the authentication application received from the monitoring server 10, any techniques of the related art can be employed.

"Flow of Processing of Authentication System"

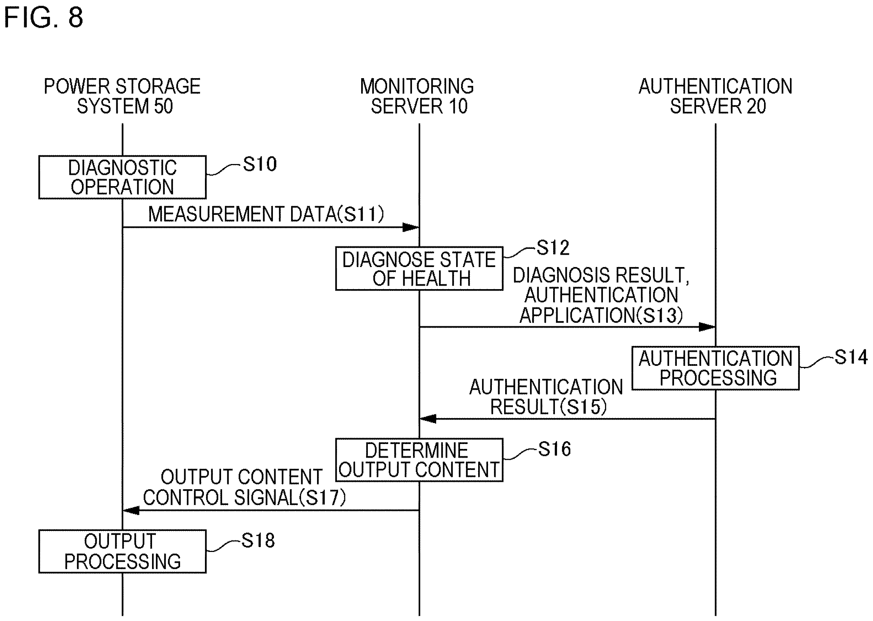

Next, an example of a flow of processing of the authentication system will be described using a sequence diagram of Fig. 8.

First, the power storage system 50 executes a diagnostic operation at a timing determined in advance or according to a request from the user and generates the measurement data regarding the power storage apparatus 51 (S10). Then, the power storage system 50 transmits the generated measurement data to the monitoring server 10 (S11). The monitoring server 10 diagnoses the state of health of the power storage apparatus 51 based on the received measurement data (S12), and transmits the diagnosis result and the authentication application to the authentication server 20 (S13). The authentication server 20 determines whether or not to authenticate that the power storage apparatus 51 is healthy, based on the received diagnosis result (S14), and transmits the determined authentication result to the monitoring server 10 (S15).

The monitoring server 10 determines the output content of the output apparatus 52 based on the received authentication result (S16), and transmits an output content control signal for outputting the determined output content to the power storage system 50 (S17). The output apparatus 52 of the power storage system 50 executes output processing following the output content control signal (S18).

In this way, the acquisition unit 11 of the monitoring server 10 acquires the measurement data generated at this timing from the power storage system 50 at the timing determined in advance or according to the request from the user. Then, the diagnosis unit 12 diagnoses the state of health of the power storage apparatus 51 with the acquisition of the measurement data by the acquisition unit 11. Then, the authentication result reception unit 13 transmits the diagnosis result to the authentication server 20 and receives the authentication result from the authentication server 20 with the diagnosis of the state of health of the power storage apparatus by the diagnosis unit 12. Then, the output content control unit 14 controls the output content of the authentication information in the output apparatus 52 with the reception of the authentication result by the authentication result reception unit 13.

"Modification Examples"

Here, modification examples of the authentication system of the present example embodiment will be described.

-Modification Example 1-

In this modification example, in S15, the authentication result is transmitted from the authentication server 20 to the power storage system 50 (not through the monitoring server 10). Then, the power storage system 50 controls the output content of the authentication information in the output apparatus 52 based on the received authentication result.

-Modification Example 2-

In this modification example, in S12, the diagnosis unit 12 performs the computation of various item values, but does not perform the comparison of various item values with the reference value. Then, the authentication result reception unit 13 transmits various item values as the diagnosis result to the authentication server 20 (S13). The authentication server 20 performs comparison of various item values with the reference value and determines whether or not to authenticate that the power storage apparatus 51 is healthy, based on a result of comparison (S14).

"Advantageous Effect"

As described above, with the authentication system of the present example embodiment, the state of health of the power storage apparatus 51 can be diagnosed, determination regarding whether or not to authenticate that the power storage apparatus 51 is healthy can be performed based on the diagnosis result, and the output apparatus 52 can make the output according to the determination result. The user can easily determine whether or not the state of the power storage apparatus 51 is healthy, based on the output content of the output apparatus 52. As a result, it is possible to reduce a burden on the user to consider the state of health of the power storage apparatus 51.

The authentication system can determine the state of health of the power storage apparatus 51 with various new distinctive methods. With the use of the new methods, it is possible to diagnose the state of health of the power storage apparatus 51 from various aspects. For example, according to the first to fourth, and ninth diagnostic methods described above, it is possible to confirm the validity of a current and voltage measurement function by the power storage system or to detect an abnormality in the positive and negative electrode materials of the cell. According to the fifth to ninth diagnostic methods described above, it is possible to confirm a state of health of a cell internal state or to detect a cell where an internal abnormality occurs, before failure occurs.

<Second Example Embodiment>

In the first example embodiment, the power storage system 50 performs the diagnostic operation at the predetermined timing (such as once a year, once every half a year, or once a month, or the timing at which the execution instruction is input from the user or the like) and performs the determination of the authentication. The monitoring server 10 of the present example embodiment has a function of determining a need for a diagnostic operation in a period between the timings and executing the diagnostic operation in a case where determination is made that there is a need for the diagnostic operation. The details will be described below.

The power storage system 50 performs measurement constantly or regularly even when a normal operation, not a diagnostic operation, is performed and transmits measurement data obtained as a result of the measurement to the monitoring server 10. The measurement data obtained with the measurement during the normal operation is data of the same kind as the measurement data obtained with the measurement during the diagnostic operation. However, in the measurement during the normal operation, the use of the power storage apparatus 51 is given priority over the measurement. For this reason, for example, control of "performing measurement with the lower limit SOC of the system usage range, then, performing charging to the upper limit SOC and performing measurement again, and performing measurement at a predetermined SOC during the period", that is, control of "performing measurement at the predetermined SOC" is difficult. Therefore, the measurement data obtained with the measurement during the normal operation is different from the measurement data obtained with the measurement during the diagnostic operation in that there is a possibility that "the measurement at the predetermined SOC" is not realized.

Then, the acquisition unit 11 of the monitoring server 10 acquires the measurement data obtained with the measurement during the normal operation transmitted from the power storage system 50 in this manner.

The diagnosis unit 12 detects a need for the diagnostic operation based on the measurement data obtained with the measurement during the normal operation. Then, in a case where determination is made that there is a need for the diagnostic operation, the diagnosis unit 12 transmits an instruction signal for executing the diagnostic operation to the power storage system 50. In a case where the instruction signal for executing the diagnostic operation is received, the power storage system 50 executes the diagnostic operation according to the instruction signal and transmits the measurement data obtained with the measurement during the diagnostic operation to the monitoring server 10. Then, the monitoring server 10 executes the processing described in the first example embodiment.

Here, the processing of detecting the need for the diagnostic operation by the diagnosis unit 12 will be described in detail. The diagnosis unit 12 can realize the detection based on any of first and second detection methods described below.

-First Detection Method-

The diagnosis unit 12 obtains X0(i) based on B(i), Cc(i), and Ca(i) computed during the last diagnostic operation and the measurement data obtained with at least two times of measurement during the normal operation. Specifically, in a case where the values of B(i), Cc(i), and Ca(i) are obtained, the variance J(i) of errors defined by Expressions (1) to (4) described above becomes a function in which X0(i) is an unknown. The diagnosis unit 12 obtains the value of X0(i) at which the variance J(i) of errors is minimized, based on this function and the measurement data obtained with the measurement during the normal operation. Then, a difference between the variance J(i) of errors at this moment (when the variance J(i) of errors is minimized) and the variance J(i) of errors during the last diagnostic operation is set as a cell-specific intermediate evaluation value. That is, in a case where variance newly obtained using B(i), Cc(i), and

$Ca(i)$ computed during the last diagnostic operation is $J_N(i)$, and the last variance is $J_0(i)$, the cell-specific intermediate evaluation value is a value obtained by subtracting $J_0(i)$ from $J_N(i)$. Diagnosis is performed using this value.

The diagnosis unit 12 can compute a sum of the cell-specific intermediate evaluation values of a plurality of cells as an intermediate evaluation value of the power storage apparatus 51.

Then, the diagnosis unit 12 determines the need for the diagnostic operation based on at least one of the cell-specific intermediate evaluation value and the intermediate evaluation value of the power storage apparatus 51.

For example, the diagnosis unit 12 determines that there is a need for the diagnostic operation, in a case where one condition of "all cell-specific intermediate evaluation values are equal to or greater than a twelfth standard value", "a predetermined proportion or more of cell-specific intermediate evaluation values are equal to or greater than the twelfth standard value", and the intermediate evaluation value of the power storage apparatus 51 is equal to or greater than a thirteenth standard value" or a condition obtained by connecting a plurality of conditions among the above-described conditions with a logical operator is satisfied.

-Second Detection Method-

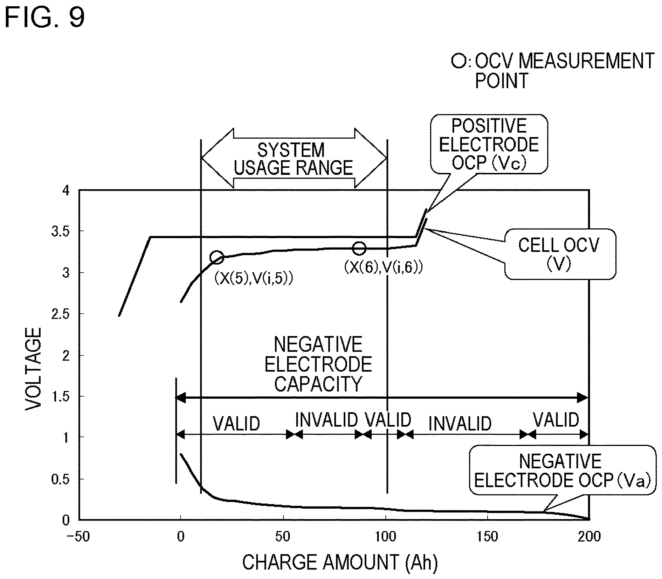

In a case where LiFePO$_4$ is used as the positive electrode, the power storage apparatus 51 is used only in a range in which the voltage is flat as illustrated in Fig. 9. On an assumption that the positive electrode voltage is constant, in a case where Sc is a fixed value, the variance $J(i)$ of errors becomes a function in which $X0(i)$ and $Ca(i)$ are unknowns. Because the unknowns are two points, the values of $X0(i)$ and $Ca(i)$ at which the variance $J(i)$ of errors is minimized can be obtained based on the measurement data of at least two times of measurement.

Because it is not the case that charging or discharging is constantly performed even during the normal operation, at least two times of measurement can be executed in a period during which charging and discharging are stopped. Then, $X0(i)$ and $Ca(i)$ can be obtained based on the measurement data with the method described in the first example embodiment. Note that, while there is a range in which the voltage of the negative electrode is also substantially constant as illustrated in Fig. 9 (in the drawing, a range of invalidation), in a case where at least two times of measurement unexpectedly enter this range, this detection processing is not executed and can be made to wait for next measurement data.

After $X0(i)$ and $Ca(i)$ are obtained, the diagnosis unit 12 determines the need for the diagnostic operation with the same method as in the first detection method.

With the authentication system of the present example embodiment, the same advantageous effects as in the first example embodiment are realized. The processing of detecting the need for the diagnostic operation can be executed during the diagnostic operation, and the diagnostic operation can be executed with the detection. For this reason, it is possible to early detect an abnormality in the power storage system 50.

<Third Example Embodiment>

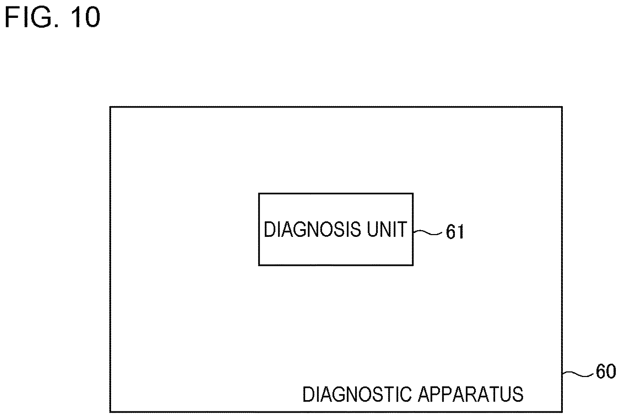

Fig. 10 illustrates an example of a functional block diagram of a diagnostic apparatus 60 of the present example embodiment. As illustrated in the drawing, the diagnostic apparatus 60 has a diagnosis unit 61. The diagnosis unit 61 diagnoses the state of health of the power storage apparatus 51 based on the measurement data regarding the power storage apparatus 51. The configuration of the diagnosis unit 61 is the same as the configuration of the diagnosis unit 12 of the monitoring server 10.

An example of the hardware configuration of the diagnostic apparatus 60 is illustrated in Fig. 3 similarly to the monitoring server 10 and the authentication server 20. As illustrated in Fig. 3, the diagnostic apparatus 60 includes a processor 1A, a memory 2A, an input/output interface 3A, a peripheral circuit 4A, and a bus 5A. The peripheral circuit 4A includes various modules. The diagnostic apparatus 60 may not have the peripheral circuit 4A. The diagnostic apparatus 60 may be configured with a plurality of physically and/or logically separated apparatuses or may be configured with one physically and/or logically integrated apparatus. In a case where the diagnostic apparatus 60 is configured with a plurality of physically and/or logically separated apparatuses, each of the plurality of apparatuses can have the above-described hardware configuration. Note that the detailed description of Fig. 3 is described above, and thus, description will not be repeated here.

With the diagnostic apparatus 60 of the present example embodiment, the advantageous effects similar to those of the first and second example embodiments are realized.

In the present specification, the term "acquisition" includes at least one of "acquisition of data stored in another apparatus or a storage medium by the apparatus (active acquisition)" based on a user input or an instruction of a program, such as reception by making a request or an inquiry to another apparatus and reading by accessing to another apparatus or a storage medium, "inputting of data output to the apparatus from another apparatus (passive acquisition)" based on a user input or an instruction of a program, such as reception of data to be distributed (transmitted, push-notified, or the like) and acquisition by selection from among received data or information, and "creation of new data by editing data (such as texting, sorting of data, extraction of a part of data, and change of a file format) and the like and acquisition of new data.

Although the present invention of the present application has been described with reference to the example embodiments (and examples), the present invention of the present application is not limited to the example embodiments (and examples). The configurations or details of the present invention of the present application can be subjected to various changes perceivable by those skilled in the art within the scope of the present invention of the present application.

A part or the whole of the example embodiments may also be described in the following supplementary notes but is not limited thereto.

1. A diagnostic apparatus including:
a diagnosis unit that diagnoses a state of health of a power storage apparatus based on an item value that is a difference between a reference value and an open-circuit voltage, the reference value being obtained by subtracting an open-circuit potential of a negative electrode of the power storage apparatus from an open-circuit potential of a positive electrode of the power storage apparatus.

2. The diagnostic apparatus according to 1,

in which the diagnosis unit
computes the open-circuit potential of the positive electrode of the power storage apparatus at the time the open-circuit voltage is measured, based on positive electrode open-circuit potential information indicating a relationship between a state of charge of the positive electrode of the power storage apparatus and the open-circuit potential of the positive electrode of the power storage apparatus,
computes the open-circuit potential of the negative electrode of the power storage apparatus at the time the open-circuit voltage is measured, based on negative electrode open-circuit potential information indicating a relationship between a state of charge of the negative electrode of the power storage apparatus and the open-circuit potential of the negative electrode of the power storage apparatus, and
computes the reference value based on results of the computation.

3. The diagnostic apparatus according to 2,

in which the diagnosis unit
computes the state of charge of the positive electrode of the power storage apparatus based on positive and negative electrode deviation, a positive electrode capacity, and a charge amount of the negative electrode of the power storage apparatus.

4. The diagnostic apparatus according to 3,

in which the diagnosis unit
computes the state of charge $Sc$ of the positive electrode of the power storage apparatus based on Expression (1) in a case where positive and negative electrode deviation of a cell $i$ is $B(i)$, a positive electrode capacity of the cell $i$ is $Cc(i)$, and a charge amount of the negative electrode of the cell $i$ in measurement of a measurement number $N$ is $A(i,N)$.

5. The diagnostic apparatus according to any one of 2 to 4,

in which the diagnosis unit
computes the state of charge of the negative electrode of the power storage apparatus based on a negative electrode capacity and a charge amount of the negative electrode of the power storage apparatus.

6. The diagnostic apparatus according to 5,

in which the diagnosis unit
computes the state of charge $Sa$ of the negative electrode of the power storage apparatus based on Expression (2) in a case where a negative electrode capacity of a cell $i$ is $Ca(i)$, and a charge amount of the negative electrode of the cell $i$ in measurement of a measurement number $N$ is $A(i,N)$.

7. The diagnostic apparatus according to any one of 3 to 6,

in which the measurement of the open-circuit voltage is performed a plurality of times under conditions in which states of charge (SOCs) of the power storage apparatus are different, and
the diagnosis unit
diagnoses the state of health of the power storage apparatus based on the positive and negative electrode deviation, the positive electrode capacity, a negative electrode capacity, and the charge amount of the negative electrode when variance $J(i)$ of errors defined by Expressions (1) to (4) is minimized, in a case where positive and negative electrode deviation of a cell $i$ is $B(i)$, a positive electrode capacity of the cell $i$ is $Cc(i)$, a negative electrode capacity of the cell $i$ is $Ca(i)$, a charge amount of the negative electrode of the cell $i$ in measurement of a measurement number N is $A(i,N)$, the open-circuit potential of the positive electrode when the state of charge of the positive electrode is $Sc$ is $Vc(Sc)$, the open-circuit potential of the negative electrode when the state of charge of the negative electrode is $Sa$ is $Va(Sa)$, and an open-circuit voltage of the cell $i$ in the measurement of the measurement number N is $V(i,N)$.

8. The diagnostic apparatus according to any one of 1 to 7,

in which measurement of the open-circuit voltage is performed for each cell a plurality of times under conditions in which SOCs of the power storage apparatus are different, and
the diagnosis unit diagnoses the state of health of the power storage apparatus based on the item value of each cell and each measurement.

9. The diagnostic apparatus according to 8,

in which the diagnosis unit
computes a sum of squares of the item values of a plurality of times of measurement for each cell as a cell-specific evaluation value, and
diagnoses the state of health of the power storage apparatus based on a sum of the cell-specific evaluation values of a plurality of cells.

10. A diagnostic method including, via a computer:
diagnosing a state of health of a power storage apparatus based on an item value that is a difference between a reference value and an open-circuit voltage, the reference value being obtained by subtracting an open-circuit potential of a negative electrode of the power storage apparatus from an open-circuit potential of a positive electrode of the power storage apparatus.
11. A program causing a computer to function as:
diagnosis unit that diagnoses a state of health of a power storage apparatus based on an item value that is a difference between a reference value and an open-circuit voltage, the reference value being obtained by subtracting an open-circuit potential of a negative electrode of the power storage apparatus from an open-circuit potential of a positive electrode of the power storage apparatus.

**Claims**

1. A diagnostic apparatus comprising:
a diagnosis unit that diagnoses a state of health of a power storage apparatus based on an item value that is a difference between a reference value and an open-circuit voltage, the reference value being obtained by subtracting an open-circuit potential of a negative electrode of the power storage apparatus from an open-circuit potential of a positive electrode of the power storage apparatus.

2. The diagnostic apparatus according to claim 1,

wherein the diagnosis unit
computes the open-circuit potential of the positive electrode of the power storage apparatus at the time the open-circuit voltage is measured, based on positive electrode open-circuit potential information indicating a relationship between a state of charge of the positive electrode of the power storage apparatus and the open-circuit potential of the positive electrode of the power storage apparatus,
computes the open-circuit potential of the negative electrode of the power storage apparatus at the time the open-circuit voltage is measured, based on negative electrode open-circuit potential information indicating a relationship between a state of charge of the negative electrode of the power storage apparatus and the open-circuit potential of the negative electrode of the power storage apparatus, and

computes the reference value based on results of the computation.

3. The diagnostic apparatus according to claim 2,

   wherein the diagnosis unit
   computes the state of charge of the positive electrode of the power storage apparatus based on positive and negative electrode deviation, a positive electrode capacity, and a charge amount of the negative electrode of the power storage apparatus.

4. The diagnostic apparatus according to claim 3,

   wherein the diagnosis unit
   computes the state of charge Sc of the positive electrode of the power storage apparatus based on Expression (1) in a case where positive and negative electrode deviation of a cell i is B(i), a positive electrode capacity of the cell i is Cc(i), and a charge amount of the negative electrode of the cell i in measurement of a measurement number N is A(i,N).

$$Sc = (B(i) + A(i,N))/Cc(i) \quad \cdots \quad (1)$$

5. The diagnostic apparatus according to any one of claims 2 to 4,

   wherein the diagnosis unit
   computes the state of charge of the negative electrode of the power storage apparatus based on a negative electrode capacity and a charge amount of the negative electrode of the power storage apparatus.

6. The diagnostic apparatus according to claim 5,

   wherein diagnosis unit
   computes_the state of charge Sa of the negative electrode of the power storage apparatus based on Expression (2) in a case where a negative electrode capacity of a cell i is Ca(i), and a charge amount of the negative electrode of the cell i in measurement of a measurement number N is A(i,N).

$$Sa = A(i,N)/Ca(i) \quad \cdots \quad (2)$$

7. The diagnostic apparatus according to any one of claims 3 to 6,

   wherein the measurement of the open-circuit voltage is performed a plurality of times under conditions in which states of charge (SOCs) of the power storage apparatus are different from each other, and
   the diagnosis unit diagnoses the state of health of the power storage apparatus based on the positive and negative electrode deviation, the positive electrode capacity, a negative electrode capacity, and the charge amount of the negative electrode when variance J(i) of errors defined by Expressions (1) to (4) is minimized, in a case where positive and negative electrode deviation of a cell i is B(i), a positive electrode capacity of the cell i is Cc(i), a negative electrode capacity of the cell i is Ca(i), a charge amount of the negative electrode of the cell i in measurement of a measurement number N is A(i,N), the open-circuit potential of the positive electrode when the state of charge of the positive electrode is Sc is Vc(Sc), the open-circuit potential of the negative electrode when the state of charge of the negative electrode is Sa is Va(Sa), and an open-circuit voltage of the cell i in the measurement of the measurement number N is V(i,N).

$$Sc = (B(i) + A(i,N))/Cc(i) \quad \cdots \quad (1)$$

$$Sa = A(i,N)/Ca(i) \quad \cdots \quad (2)$$

$$R(i,N) = Vc(Sc) - Va(Sa) - V(i,N) \quad \cdots \quad (3)$$

$$J(i) = \sum_{N=1}^{n} (R(i,N))^2 \quad \cdots \quad (4)$$

8. The diagnostic apparatus according to any one of claims 1 to 7,

   wherein measurement of the open-circuit voltage is performed for each cell a plurality of times under conditions in which SOCs of the power storage apparatus are different from each other, and
   the diagnosis unit diagnoses the state of health of the power storage apparatus based on the item value of each cell and each measurement.

9. The diagnostic apparatus according to claim 8,

   wherein the diagnosis unit
   computes a sum of squares of the item values of a plurality of times of measurement for each cell as a cell-specific evaluation value, and
   diagnoses the state of health of the power storage apparatus based on a sum of the cell-specific evaluation values of a plurality of cells.

10. A diagnostic method comprising, via a computer:
    diagnosing a state of health of a power storage apparatus based on an item value that is a difference between a reference value and an open-circuit voltage, the reference value being obtained by subtracting an open-circuit potential of a negative electrode of the power storage apparatus from an open-circuit potential of a positive electrode of the power storage apparatus.

11. A program causing a computer to function as:
    diagnosis unit that diagnoses a state of health of a power storage apparatus based on an item value that is a difference between a reference value and an open-circuit voltage, the reference value being obtained by subtracting an open-circuit potential of a negative electrode of the power storage apparatus from an open-circuit potential of a positive electrode of the power storage apparatus.

# FIG. 1

EP 4 283 754 A1

FIG. 2

MEASUREMENT DATA
APPARATUS ID, OPERATION MODE (ON DIAGNOSIS OR NORMAL OPERATION), SOC, CURRENT, CHARGE CURRENT INTEGRATED VALUE, DISCHARGE CURRENT INTEGRATED VALUE, CELL VOLTAGE, TEMPERATURE, AND THE LIKE

OUT
POWER STORAGE SYSTEM
IN

50(51,52,53)

30

MONITORING DATABASE
APPARATUS ID, POSITIVE ELECTRODE AND NEGATIVE ELECTRODE OCP, MEASUREMENT DATA, DIAGNOSIS RESULT, AUTHENTICATION HISTORY, AND THE LIKE

OUTPUT CONTENT CONTROL SIGNAL OF AUTHENTICATION INFORMATION

IN          OUT
IN/OUT   MONITORING SERVER
OUT          IN

10

40

AUTHENTICATION DATABASE
APPARATUS ID, POSITIVE ELECTRODE AND NEGATIVE ELECTRODE OCP, MEASUREMENT DATA, DIAGNOSIS RESULT, AUTHENTICATION HISTORY, AND THE LIKE

AUTHENTICATION APPLICATION, DIAGNOSIS RESULT

DIAGNOSIS RESULT

20

AUTHENTICATION RESULT

IN   AUTHENTICATION SERVER
IN/OUT          OUT

EP 4 283 754 A1

FIG. 3

INPUT/
OUTPUT I/F — 3A

5A

PROCESSOR

MEMORY

PERIPHERAL
CIRCUIT

1A

2A

4A

FIG. 4

# EP 4 283 754 A1

## FIG. 5

FIG. 6

# FIG. 7

O: OCV MEASUREMENT POINT

SYSTEM USAGE RANGE

POSITIVE ELECTRODE OCP (Vc)

CELL OCV (V)

(X(1),V(i,1))

(X(4),V(i,4))

NEGATIVE ELECTRODE CAPACITY

NEGATIVE ELECTRODE OCP (Va)

VOLTAGE

CHARGE AMOUNT (Ah)

# FIG. 8

POWER STORAGE SYSTEM 50      MONITORING SERVER 10      AUTHENTICATION SERVER 20

DIAGNOSTIC OPERATION ~S10

MEASUREMENT DATA(S11)

DIAGNOSE STATE OF HEALTH ~S12

DIAGNOSIS RESULT, AUTHENTICATION APPLICATION(S13)

AUTHENTICATION PROCESSING ~S14

AUTHENTICATION RESULT(S15)

DETERMINE OUTPUT CONTENT ~S16

OUTPUT CONTENT CONTROL SIGNAL(S17)

OUTPUT PROCESSING ~S18

EP 4 283 754 A1

FIG. 9

◯ : OCV MEASUREMENT
POINT

POSITIVE
ELECTRODE
OCP (Vc)

SYSTEM
USAGE RANGE

CELL OCV
(V)

(X(5),V(i,5))

(X(6),V(i,6))

NEGATIVE
ELECTRODE
CAPACITY

VALID | INVALID | VALID | INVALID | VALID

NEGATIVE
ELECTRODE OCP (Va)

VOLTAGE

CHARGE AMOUNT (Ah)

FIG. 10

DIAGNOSIS UNit ~ 61

~ 60

DIAGNOSTIC APPARATUS

# FIG. 11

FIG. 12

# FIG. 13

SYSTEM USAGE RANGE

OCP (V)

STATE OF CHARGE (SOC)

dV/d(SOC) (mV/%)

——- POSITIVE ELECTRODE OCP          ——- POSITIVE ELECTRODE OCP dV/dSOC

—— Cell OCV                                    ------ NEGATIVE ELECTRODE OCP dV/dSOC

---- NEGATIVE ELECTRODE OCP

EP 4 283 754 A1

# FIG. 14

$$SOC_{①}=Ca \cdot SOC_{a①}/C_{cell}$$

$$SOC_{②}=Cc \cdot SOC_{c②}/C_{cell} - B/C_{cell}*100$$

$$SOC_{③}=Ca \cdot SOC_{a③}/C_{cell}$$

$$SOC_{④}=Cc \cdot SOC_{c④}/C_{cell} - B/C_{cell}*100$$

HERE $SOC_{①}$ TO $SOC_{④}$ ARE SOC OF BATTERY SYSTEM, $SOC_{a①}$ AND $SOC_{a③}$ ARE SOC SELECTED SUCH THAT dV/dSOC OF NEGATIVE ELECTRODE INCREASES, AND $SOC_{c②}$ AND $SOC_{c④}$ ARE SOC SELECTED SUCH THAT dV/dSOC OF POSITIVE ELECTRODE INCREASES.

# FIG. 15

WITH RESPECT TO N = 1 TO 3

$$R(i,N)=Vc(Sct,Sc)-Vc(Sat,Sa)-V(i,N)$$

HERE

$$Sct=(B(i)+A(i,4))/Cc(i)=(B(i)+X(4)-X0(i))/Cc(i)$$

$$Sc=(B(i)+A(i,N))/Cc(i)=(B(i)+X(N)-X0(i))/CC(i)$$

$$Sat=A(i,4)/Ca(i)=(X(4)-X0(i))/Ca(i)$$

$$Sa=A(i,N)/Ca(i)=(X(N)-X0(i))/Ca(i)$$

WITH RESPECT TO N = 4

$$R(i,N)=Vc(Sct,Sc)-Vc(Sat,Sa)-V(i,N)$$

HERE

$$Sct=(B(i)+A(i,0))/Cc(i)=(B(i)+X(0)-X0(i))/Cc(i)$$

$$Sc=(B(i)+A(i,N))/Cc(i)=(B(i)+X(N)-X0(i))/CC(i)$$

$$Sat=A(i,1)/Ca(i)=(X(1)-X0(i))/Ca(i)$$

$$Sa=A(i,N)/Ca(i)=(X(N)-X0(i))/Ca(i)$$

## FIG. 16

## FIG. 17

$$V = V_1 + V_2 + V_{ocv}$$

$$I_{R1+}I_{C1} = I_{R2+}I_{C2} = 0$$

$$V_1 = I_{R1} \cdot R_1 = V_{1,ini} + \int I_{C1} dt / C_1$$

$$V_2 = I_{R2} \cdot R_2 = V_{2,ini} + \int I_{C2} dt / C_2,$$

**INTERNATIONAL SEARCH REPORT**

International application No.

PCT/JP2021/001760

### A. CLASSIFICATION OF SUBJECT MATTER
H01M 10/48(2006.01)i; H02J 7/00(2006.01)i; G01R 31/385(2019.01)i
FI: H01M10/48 P; H02J7/00 Q; G01R31/385

According to International Patent Classification (IPC) or to both national classification and IPC

### B. FIELDS SEARCHED

Minimum documentation searched (classification system followed by classification symbols)
H01M10/48; H02J7/00; G01R31/385

| Documentation searched other than minimum documentation to the extent that such documents are included in the fields searched | |
|---|---|
| Published examined utility model applications of Japan | 1922–1996 |
| Published unexamined utility model applications of Japan | 1971–2021 |
| Registered utility model specifications of Japan | 1996–2021 |
| Published registered utility model applications of Japan | 1994–2021 |

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| Y<br>A | JP 2018-173370 A (SUMITOMO ELECTRIC INDUSTRIES, LTD.) 08 November 2018 (2018-11-08) paragraphs [0001], [0035], [0039], [0066] | 1-3, 5, 6, 8, 10, 11<br>4, 7, 9 |
| Y | WO 2010/026930 A1 (TOYOTA CENTRAL R&D LABS., INC.) 11 March 2010 (2010-03-11) paragraphs [0078], [0080]-[0082], [0092], [0095]-[0097], [0162], [0163] | 1-3, 5, 6, 8, 10, 11 |

☐ Further documents are listed in the continuation of Box C.　☒ See patent family annex.

| | | |
|---|---|---|
| * | Special categories of cited documents: | |
| "A" | document defining the general state of the art which is not considered to be of particular relevance | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

| | |
|---|---|
| "T" | later document published after the international filing date or priority date and not in conflict with the application but cited to understand the principle or theory underlying the invention |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>01 April 2021 (01.04.2021) | Date of mailing of the international search report<br>13 April 2021 (13.04.2021) |
|---|---|
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

| INTERNATIONAL SEARCH REPORT | | International application No. | |
|---|---|---|---|
| Information on patent family members | | PCT/JP2021/001760 | |

| Patent Documents referred in the Report | Publication Date | Patent Family | Publication Date |
|---|---|---|---|
| JP 2018-173370 A | 08 Nov. 2018 | (Family: none) | |
| WO 2010/026930 A1 | 11 Mar. 2010 | US 2011/0161025 A1<br>paragraphs [0123],<br>[0125]-[0126],<br>[0133], [0136]-<br>[0138], [0189],<br>[0190]<br>EP 2325664 A1<br>CN 102144169 A<br>JP 2010-60384 A | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5537236 B

**Non-patent literature cited in the description**

- **MORITA TOMOKAZU.** *Charging Curve Analysis Method to Visualize State of Health of Lithium-Ion Batteries through Internal State Estimation,* 08 October 2019, https://www.toshiba.co.jp/tech/review/2013/10/68_10pdf/f07.pdf
- **RASHID, M ; PATHAN, T ; MCGORDON, A ; KENDRICK, E ; WIDANAGE.** Investigation of hysteresis and relaxation behaviour in graphite and LiNi Mn Co O electrodes. *Journal of Power Sources,* 2019, vol. 440, 227153

- **F. BARONTI ; W. ZAMBONI ; N. FEMIA ; R. RONCELLA ; R. SALETTI.** Experimental Analysis of Open-Circuit Voltage Hysteresis in Lithium-Iron-Phosphate Batteries. *IECON 2013 -39th Annual Conference of the IEEE Industrial Electronics Society,* 2013